(19) 

**Europäisches Patentamt**
**European Patent Office**
**Office européen des brevets**

(11) **EP 1 447 841 B1**

(12) **EUROPEAN PATENT SPECIFICATION**

(45) Date of publication and mention
of the grant of the patent:
**28.04.2010 Bulletin 2010/17**

(51) Int Cl.:
***H01L 21/304*** (2006.01)

(21) Application number: **03784605.2**

(22) Date of filing: **08.08.2003**

(86) International application number:
**PCT/JP2003/010125**

(87) International publication number:
**WO 2004/015751 (19.02.2004 Gazette 2004/08)**

(54) **METHOD OF MACHINING SEMICONDUCTOR WAFER-USE POLISHING PAD AND SEMICONDUCTOR WAFER-USE POLISHING PAD**

POLIERSTÜCK FÜR EIN VERFAHREN ZUR BEARBEITUNG VON HALBLEITERWAFERN UND POLIERSTÜCK FÜR HALBLEITERWAFER

PROCEDE D'USINAGE D'UN TAMPON A POLIR POUR PLAQUETTE DE SEMI-CONDUCTEUR ET TAMPON A POLIR POUR PLAQUETTE DE SEMI-CONDUCTEUR

(84) Designated Contracting States:
**DE FR IT**

(30) Priority: **08.08.2002 JP 2002231943**
**25.10.2002 JP 2002311951**

(43) Date of publication of application:
**18.08.2004 Bulletin 2004/34**

(73) Proprietor: **JSR Corporation**
**Tokyo 104-8410 (JP)**

(72) Inventors:
• **SHIHO, Hiroshi,**
**c/o JSR Corporation**
**Chuo-ku,**
**Tokyo 104-8410 (JP)**

• **HASEGAWA, Kou,**
**c/o JSR Corporation**
**Chuo-ku,**
**Tokyo 104-8410 (JP)**
• **KAWAHASHI, Nobuo,**
**c/o JSR Corporation**
**Chuo-ku,**
**Tokyo 104-8410 (JP)**

(74) Representative: **TBK-Patent**
**Bavariaring 4-6**
**80336 München (DE)**

(56) References cited:
**EP-A2- 1 201 368     JP-A- 2001 018 164**
**JP-A- 2001 214 154     JP-A- 2002 011 630**
**JP-A- 2002 184 730**

**Description**

The present invention relates to a processing method of a polishing pad for semiconductor wafer having a groove, a concave portion, a through hole and the like on a polishing surface of the polishing pad by this method. More specifically, the invention relates to a processing method of a polishing pad for semiconductor wafer in order to form an annular groove, a lattice-like groove, a spiral groove, a plurality of concave portions, a through hole and the like on a polishing surface of the polishing pad. The polishing pad for semiconductor wafer obtained by this method is used for Chemical Mechanical Polishing (hereinafter referred to as "CMP") of a semiconductor wafer and the like. An example of a polishing pad obtained by such a method is disclosed in EP-A-201 368.

For CMP of a semiconductor wafer, a polishing pad made of resin is often used. An annular groove, a lattice-like groove, a spiral groove and the like are disposed on a polishing surface of the polishing pad in some cases for the purpose of retaining a slurry for CMP, temporarily storing polishing wastages and the like. This groove is formed by a method such as cutting and metal molding, and various improvements have been made in each of the methods (for example in JP-A-2002-11630 and the like). An annular groove is, for instance, formed by using a machining apparatus having a lathe function provided with a turntable having a positioning mechanism for feeding a polishing pad to be processed in the pitch direction of the groove and a cutter holder capable of cutting in the depth direction of the groove, and a turning tool is mounted on the cutter holder. In addition, a lattice-like groove is formed as follows: a plurality of grooves in parallel is indexed on a machining center or planar by feeding a cutting tool and the like straight, and a rotary table is disposed to machine them by a rotary tool or a cutting tool.

In order to polish a surface of the semiconductor wafer uniformly and obtain a surface excellent in planarity, a polishing pad whose dimensional accuracy is high, surface roughness of the inner surface is small and inner surface is uniform in grooves, is required to use. However, against a polishing pad composed of a foam made of a conventional resin, it is difficult to cut minutely in depth direction of the groove even though such a machining apparatus is used for cutting. Moreover, since the polishing pad is not so thick, an annular or a lattice-like groove with high dimensional accuracy in width and depth cannot be formed throughout the surface from time to time. Further, there is a problem that surface roughness of the inner surface of the groove is increased after cutting.

In JP-A-2001-18164, a machining tool for forming a groove on a polishing surface of a polishing pad composed of a foam made of a conventional resin is disclosed.

A method for producing a polishing pad is also disclosed in the EP-A-1 201 368. The method for producing the polishing pad according to that disclosure comprises a first step of kneading a formulation (I) comprising (a) a crosslinkable elastomer having no carboxyl, amino, hydroxyl, epoxy, sulfonic acid and phosphoric acid groups and (b) a water-insoluble substance having at least one functional group selected from the group consisting of a carboxyl, amino, hydroxyl, epoxy, sulfonic acid and phosphoric acid groups, and a second step for molding into a polishing pad.

The present invention is to solve the above problems and is intended to provide a processing method of a polishing pad for semiconductor wafer capable of forming a groove, a concave portion, a through hole and the like, having a small surface roughness of the inner surface, a high dimensional accuracy and a uniform cross-sectional shape on the polishing surface of a polishing pad made of a specific composition, not composed of a foam made of a conventional resin, and also to provide a polishing pad for semiconductor wafer having a groove processed by this method and capable of suppressing a generation of a scratch and a dishing when used for CMP.

And the present invention is to attain the above intentions and is characterized in forming at least one part selected from the group consisting of a groove, a concave portion and a through hole having each surface roughness of inner surface of 20 μm or less by processing a polishing surface of a polishing pad comprising a water-insoluble matrix containing a crosslinked polymer and a water-soluble particle dispersed in the water-insoluble matrix.

The above problems are solved by the subject - matter of claims 1 or 2.

In the following, the present invention will be detailed. The present invention is a processing method of a polishing part (polishing surface side) of a solid polishing pad which is not composed of a foam to form a groove, a concave portion and a through hole having a variety of shapes.

[1] Polishing pad

A polishing pad to be processed in the present invention has a property for the polishing surface as follows. That is, a pore having a function of retaining a slurry during polishing, allowing a wastage to stay temporarily and the like is to be formed on the polishing surface up to the time of polishing. Therefore, the polishing pad to be processed in the present invention is provided with a water-insoluble matrix and a water-soluble particle dispersed in the water-insoluble matrix. The water-soluble particle is dropped off the polishing surface by contacting a slurry (i.e., an aqueous dispersion containing a medium component and a solid component) to dissolve in the aqueous medium or to swell. And the slurry is retained in the pore formed by dropping off.

A material that constitutes the "water-insoluble matrix" is not particularly limited. In view of being easy to mold into a predetermined shape, property and state, and being capable of endowing an appropriate hardness, an appropriate elasticity and the like, it is usual to use an organic material. As the organic material, a thermoplastic resin, an elastomer, a rubber, a curable resin (i.e., a resin to be cured owing to heat, light and the like such as a thermo-setting resin and a photo-setting resin) and the like may be used alone or in combination of two or more kinds.

Among these, the thermoplastic resin includes 1,2-polybutadiene resin, a polyolefinic resin such as ethylene-vinyl acetate copolymer resin and polyethylene, a polystyrene-based resin, a polyacrylic resin such as (meth)acrylate-based resin, a vinylester-based resin (except for acrylic-based resin), a polyester-based resin, a polyamide-based resin, a fluorinated resin such as polyvinylidene fluoride, a polycarbonate resin, a polyacetal resin and the like.

The elastomer includes a diene-based elastomer such as 1,2-polybutadiene, a polyolefinic elastomer (TPO), a styrene-based elastomer such as styrene-butadiene-styrene block copolymer (SBS) and hydrogenated block copolymer thereof (SEBS), a thermoplastic elastomer such as thermoplastic polyurethane-based elastomer (TPU), thermoplastic polyester-based elastomer (TPEE) and polyamide-based elastomer (TPAE), a silicone resin-based elastomer, a fluorinated resin-based elastomer and the like.

The rubber includes a conjugated diene-based rubber such as butadiene-based rubber (high-cis butadiene rubber, low-cis butadiene rubber and the like), isoprene-based rubber, styrene-butadiene-based rubber and styrene-isoprene-based rubber, a nitrile-based rubber such as acrylonitrile-butadiene-based rubbers, an acrylic rubber, an ethylene-$\alpha$-olefin-based rubber such as ethylene-propylene-based rubber, ethylene-propylene-diene-based rubbers, and other rubbers such as butyl rubber, silicone rubber and fluororubber, and the like.

The curable resin includes an urethane-based resin, an epoxy-based resin, an acrylic resin, an unsaturated polyester-based resin, a polyurethane-urea-based resin, an urea-based resin, a silicone-based resin, a phenol-based resin, a vinylester-based resin and the like.

Furthermore, the organic material may be a one having a functional group such as an acid anhydride group, a carboxyl group, a hydroxyl group, an epoxy group and an amino group. By having such a functional group, the organic material can be controlled in its affinity with the water-soluble particle described below and a slurry.

The organic materials may be used alone or in combination of two or more kinds.

In the present invention, the water-insoluble matrix may comprise a crosslinked polymer at least. Therefore, these organic materials may be a crosslinked polymer that is entirely crosslinked, or may be a combination of a partially-crosslinked polymer and a non-crosslinked polymer. When the crosslinked polymer is contained, the polishing pad is endowed with an elastic recovering force and a displacement due to a shearing-stress applied on the polishing pad during polishing can be suppressed small. Furthermore, the water-insoluble matrix can be effectively suppressed from being excessively elongated and plastic-deformed to bury the pores during polishing and dressing, and furthermore, a surface of the polishing pad can be effectively suppressed from becoming excessively fluffy. Accordingly, even during dressing, the pores can be effectively formed, and the slurry retaining power during polishing can be inhibited from deteriorating. Furthermore, since the surface of the polishing pad is less fluffy, the polishing flatness is not disturbed. A method of crosslinking is not particularly limited; that is, a chemical crosslinking with an organic peroxide, a sulfur, a sulfur compound and the like, a radiation crosslinking with an electron beam or the like, and the like can be applied. Since a polishing for a semiconductor is preferably proceeding without a contaminant of sulfur and the like, an organic peroxide is preferred in the case of a chemical crosslinking. The organic peroxide includes dicumyl peroxide, di-t-butyl peroxide, diethyl peroxide, diacetyl peroxide and the like. The organic peroxide may be used alone or in combination of two or more kinds. An amount of the crosslinking agent to be used is preferably 5 % by mass or less, more preferably 0.01 to 4 % by mass and especially 0.1 to 3 % by mass based on a crosslinkable (co)polymer.

As this crosslinked polymer, a crosslinked rubber, a cured resin, a crosslinked thermoplastic resin, a crosslinked elastomer and the like among the organic material can be used. Further among these, in view of being stable to strong acids and strong alkalis contained in many slurries and being less in the softening due to water absorption, a crosslinked thermoplastic resin and a crosslinked elastomer are preferable. As the crosslinked thermoplastic resin, crosslinked 1,2-polybutadiene (hereinafter referred to as "crosslinked PBD") and crosslinked ethylene-vinyl acetate copolymer (hereinafter referred to as "crosslinked EVA") are preferably used. Furthermore, among the crosslinked thermoplastic resin and the crosslinked elastomer, one that is crosslinked with an organic peroxide is particularly preferable.

A content of the crosslinked polymer is 15 % by mass or more, more preferably 20 % by mass or more, further more preferably 30 % by mass or more based on 100 % by mass of a total of the water-insoluble matrix. The water-insoluble matrix may all be consisted of a crosslinked polymer. When the content of the crosslinked polymer in the water-insoluble matrix is less than 15 % by mass, an effect of containing the crosslinked polymer cannot be sufficiently exhibited in some cases.

The water-insoluble matrix containing the crosslinked polymer, when a specimen made of the water-insoluble matrix is broken at 80 °C according to JIS K 6251, can make an elongation that remains after breaking (hereinafter, simply referred to as "elongation remaining after breaking") 100 % or less. That is, a total length between markers after breaking is two times or less a length between markers before breaking. The elongation remaining after breaking is preferably 30 % or less, more preferably 10 % or less, particularly preferably 5 % or less, and normally 0 % more. When the elongation remaining after breaking exceeds 100 %, fine fragments scraped or stretched out from a surface of the polishing pad during polishing or dressing unfavorably tend to clog the pores. When, according to JIS K 6251 "Elongation Test Method of Vulcanized Rubber", with a test sample having a shape of dumbbell No. 3, and under the conditions of a pulling rate of 500 mm/min and a test temperature of 80 °C, a test sample is broken, the "elongation remaining after breaking" is defined as an elongation rate of a length that is obtained by subtracting a length between markers before the test from a total length of the respective lengths from the markers to the broken portion of the test sample that are separated by breaking to the length between markers before the test. Furthermore, in actual polishing, there is heat generation due to the sliding; accordingly, the test is carried out at 80 °C.

In the case of employing crosslinked PBD, crosslinked EVA or the like as the crosslinked polymer, a surface roughness of the inner surface of the groove and the like after processing can be easily 20 $\mu$m or less. The surface roughness of 20$\mu$m or less leads to an effective function of distributing a slurry on the polishing surface and exhausting wastages outside in addition to inhibiting scratches. Moreover, in the case of forming a groove, a concave portion or a through hole having a variety of shapes by using a machining apparatus described below, the resultant polishing pad shows a high accuracy and a stable shape in a groove and the like and is one excellent in planarity on the whole surface.

The "water-soluble particle" is a particle that drops off from the water-insoluble matrix when the polishing pad comes into contact, in the polishing pad, with the slurry that is an aqueous dispersion. The dropping-off may be caused by dissolving when the water-soluble particles come into contact with water or the like contained in the slurry, or may be caused by swelling and becoming gel-like when the water-soluble particle contains water and the like. Furthermore, the dissolution or the swelling may be caused not only by contact with water but also with an aqueous mixture medium containing an alcoholic solvent such as methanol.

The water-soluble particle has, other than the effect of forming a pore, in the polishing pad, another effect of making the indentation hardness of the polishing pad larger and thereby making an amount of indentation of the material to be polished due to the depression smaller. That is, when the polishing pad to be processed in the present invention contains a water-soluble particle, Shore D hardness thereof can be made preferably 35 or more, more preferably in the range of from 50 to 90, further more preferably from 60 to 85, and usually 100 or less. When Shore D hardness is 35 or more, a pressure that can be applied on the material to be polished can be made larger, and accompanying this, a removal rate can be improved. In further addition to this, a high polishing flatness can be obtained. Accordingly, the water-soluble particle is particularly preferable to be solid body that can secure a sufficient indentation hardness in the polishing pad.

A material that constitutes the water-soluble particle is not particularly limited. An organic water-soluble particle and an inorganic water-soluble particle can be used. As the organic water-soluble particle, one that is made of a saccharide (polysaccharide such as starch, dextrin and cyclodextrin, lactose, mannite and the like), a cellulose (hydroxypropyl cellulose, methyl cellulose and the like), protein, polyvinyl alcohol, polyvinyl pyrrolidone, polyacrylic acid and its salt, polyethylene oxide, water-soluble photosensitive resin, sulfonated polyisoprene, sulfonated polyisoprene copolymers and the like can be used. In addition, as the inorganic water-soluble particle, one made of potassium acetate, potassium nitrate, potassium carbonate, potassium hydrogen carbonate, potassium chloride, potassium bromide, potassium phosphate, magnesium nitrate and the like can be used. The material constituting the water-soluble particle may be used alone or in combination of two or more kinds. Furthermore, the water-soluble particle may be one kind of water-soluble particle made of a predetermined material or two or more kinds of water-soluble particles made of different materials.

An average particle diameter of the water-soluble particle is preferably in the range of from 0.1 to 500 $\mu$m, more preferably from 0.5 to 100 $\mu$m, and further more preferably from 1 to 50 $\mu$m. That is, a magnitude of the pore is preferably in the range of from 0.1 to 500 $\mu$m, more preferably from 0.5 to 100 $\mu$m, and further more preferably from 1 to 50 $\mu$m. When an average particle diameter of the water-soluble particle is less than 0.1 $\mu$m, a magnitude of the formed pore becomes smaller than the abrasive, and accordingly, it is not easy to obtain a polishing pad that can sufficiently retain a slurry. On the other hand, when the average particle diameter exceeds 500 $\mu$m, the magnitude of the pore to be formed becomes excessively large and as a result, a mechanical strength of the obtained polishing pad and a removal rate tend to deteriorate.

A content of the water-soluble particle is preferably in the range of from 0.1 to 90 % by volume, more preferably in the range of from 0.5 to 60 % by volume and further more preferably from 1 to 40 % by volume based on 100 % by volume of a total of the water-insoluble matrix and the water-soluble particle. When the content of the water-soluble particle is less than 0.1 % by volume, a pore cannot be sufficiently formed on the polishing surface of the polishing pad, and the removal rate tends to decrease. On the other hand, when the content of the water-soluble particle exceeds 90 % by volume, it tends to be difficult to sufficiently inhibit the water-soluble particle present within the polishing pad from swelling or dissolving, and accordingly, it becomes difficult to maintain hardness and mechanical strength of the polishing pad at proper values.

In addition, it is preferable that the water-soluble particle is dissolved in water only when exposed on a surface layer of the polishing pad, and does not absorb moisture when being within the polishing pad and further swell. Therefore, at least a part of the outermost part of the water-soluble particle may be provided with an outer shell that suppresses a moisture absorption. The outer shell may be physically absorbed by the water-soluble particle, or may form a chemical bond with the water-soluble particle, or may come into contact with the water-soluble particle through both of the above. A material that constitutes such outer shell includes an epoxy resin, a polyimide, a polyamide, a polysilicate and the like. The outer shell, even when only a part of the water-soluble particle is provided therewith, can exhibit sufficiently the effect.

The polishing pad to be processed in the present invention comprises a water-insoluble matrix and a water-soluble particle, however, it may contain other compounding agents as necessary. As the compounding agents, a compatibilizing agent, a filler, a surfactant, an abrasive, a softener, an anti-oxidizer, a UV-absorber, an anti-static agent, a lubricant, a plasticizer and the like may be used. These may be one of each or in combination of two or more kinds.

The use of the compatibilizing agent can control an affinity between the water-insoluble matrix and the water-soluble particle and a dispersibility of the water-soluble particle in the water-insoluble matrix. The compatibilizing agent includes a polymer having two or more functional groups selected from an acid anhydride group, a carboxyl group, a hydroxyl group, an epoxy group, an oxazoline group and an amino group in one molecule, a coupling agent and the like.

In addition, the use of the filler can improve a rigidity of the polishing pad. A material that constitutes the filler includes calcium carbonate, magnesium carbonate, talc, clay and the like.

As the surfactant, a cationic surfactant, an anionic surfactant and a nonionic surfactant may be used. Of these, the cationic surfactant includes an aliphatic amine salt, an aliphatic ammonium salt and the like. The anionic surfactant includes a carboxylate such as fatty acid soap and alkyl ether carboxylate, a sulfonate such as alkyl benzene sulfonate, alkyl naphthalene sulfonate and $\alpha$-olefin sulfonates, a sulfuric ester salt such as sulfuric ester salt of higher alcohol, an alkyl ether sulfate, a polyoxyethylene alkylphenyl ether.sulfate, a phosphoric ester salt such as alkyl phosphoric ester salt and the like. And the nonionic surfactant includes an ether-type surfactant such as polyoxyethylene alkylether, an ether-ester type surfactant such as polyoxyethylene of glycerol, an ester-type surfactant such as polyethylene glycol fatty acid ester, glycerol ester and sorbitan ester and the like.

As the abrasive, a particle made of silica, alumina, ceria, zirconia, titanium oxide or the like may be used. In the case of polishing with a polishing pad containing this abrasive, a water for instance may be used instead of a slurry for chemical mechanical polishing. It is noted that using at least one selected from an oxidizer, an anti-scratch agent and a pH adjustor is preferable in the case of using this abrasive.

The oxidizer includes hydrogen peroxide, peracetic acid, perbenzoic acid, an organic peroxide such as tert-butyl hydroperoxide, a permanganate such as potassium permanganate, a dichromate such as potassium dichromate, a halogen acid compound such as potassium iodate, a nitrate such as nitric acid and iron nitrate, a perhalogen acid compound such as perchloric acid, a persulfate such as ammonium persulfate, a heteropolyacid and the like. Among these, a persulfate such as ammonium persulfate in addition to hydrogen peroxide and an organic peroxide whose decomposition products are not harmful is particularly preferable.

The anti-scratch agent includes bisphenol, bipyridyl, 2-vinylpyridine, 4- vinylpyridine, salicylaldoxime, o-phenylenediamine, m-phenylenediamine, catechol, o-aminophenol, thiourea, N-alkyl group-containing (meth)acrylamide, N-aminoalkyl group-containing (meth)acrylamide, 7-hydroxy-5- methyl-1,3,4-triazaindolizine, 5-methyl-1H-benzotriazole, phthalazine, melamine, 3-amino-5,6-dimethyl-1,2,4-triazine and the like.

The pH adjustor is a component that is not including in the compounding agent and has a property of acid or basic in the case of coming into contact with water. As the pH adjustor, an acid, ammonia, a hydroxide of alkali metal and the like may be used.

As the acid, an organic acid and an inorganic acid may be used. Among these, the organic acid includes para-toluene sulfonic acid, dodecyl-benzene sulfonic acid, isoprene sulfonic acid, gluconic acid, lactic acid, citric acid, tartaric acid, malic acid, glycolic acid, malonic acid, formic acid, oxalic acid, succinic acid, fumaric acid, maleic acid, phthalic acid and the like. In addition, the inorganic acid includes nitric acid, hydrochloric acid, sulfuric acid and the like. The acid may be used alone or in combination of two or more kinds.

The hydroxide of alkali metal includes sodium hydroxide, potassium hydroxide, rubidium hydroxide, cesium hydroxide and the like.

A shape of the polishing pad to be processed is not particularly limited, and may be a disc-like one, a belt-like one, a roller-like one and the like. In addition, a magnitude of the polishing pad is not particularly limited. For instance, in case of a disc-like one, a polishing pad having a diameter in the range of from 0.5 to 500 cm and a thickness of exceeding 0.1 mm and 100 mm or less is preferably used.

Further, a method for obtaining such polishing pad is not particularly limited. For instance, a composition for polishing pad is prepared and this composition is molded or processed into a prescribed shape to a polishing pad.

A method for obtaining such a composition for polishing pad is not particularly limited. It can be prepared by kneading a polymer forming a water-insoluble matrix, a water-soluble particle and other additives by use of a kneading machine and the like. The kneading machine that has been known may be used and includes a kneading machine such as a roller, a kneader, Banbary mixer, an extruder (single shaft, multi-shaft) and the like. When they are kneaded, they are usually heated in order to allow easily working. At a temperature of kneading, it is preferable that the water-soluble particle is solid. In the case the water-soluble particle is solid, irrespective of a magnitude of the compatibility with the water-insoluble matrix, the water-soluble particle can be dispersed with a preferable average diameter. Therefore, it is preferable to select a kind of the water-soluble particle in accordance with a working temperature of the water-insoluble matrix to be used.

[2] Processing method

In the present invention, processing method such as a cutting (including a turning cutting) and a laser-beam processing leads to a forming of a groove and the like on a polishing surface of a polishing pad. Among these, a cutting is preferable.

In the present invention, in the case a polishing pad is processed by a cutting, a machining apparatus comprising, for example,

a bed;

a round table in which a sucking hole is bored in the upper end surface of a hollow center shaft rotatably borne about the Z-axis orthogonal to the bed, a horizontal vacuum plate for placing and vacuuming a polishing pad for semiconductor wafer is disposed, and the sucking hole is communicated with a hole of the hollow center shaft;

a drive mechanism for rotating the round table and positioning an index position;

a gantry type column in which a cross rail is disposed movably in the X-axis direction orthogonal to the Z-axis as the cross rail steps over the round table above the bed;

two saddles disposed on the cross rail separately, movably in the Y-axis direction orthogonal to the Z- and X-axes;

two cutter holders disposed on the saddles separately, movably in the Z-axis direction, the cutter holders having a rotary tool placed on one of them and a fixing tool placed on the other;

a drive motor for moving and positioning each of the round table, the gantry type column, the two saddles, and the two cutter holders; and

a numerical control apparatus for controlling the drive motor can be used.

In addition, a machining apparatus having a single saddle disposed movably in Y-axis direction orthogonal to Z- and X-axes on a cross rail, instead of the two saddles disposed separately, movably in the Y-axis direction orthogonal to the Z- and the X-axes on the cross rail, respectively, and a single cutter holder which is disposed movably in the Z-axis direction on a saddle, and wherein a rotary tool and a fixing tool are changeable, instead of the two cutter holders disposed separately, movably in the Z-axis direction on the saddle, respectively, and the two cutter holders having the rotary tool placed on one of them and the fixing tool placed on the other.

The machining apparatus can be provided with the following components:

(1) Round table
(2) Gantry type column
(3) Two saddles placed on a cross rail
(4) Two cutter holders placed on each of the two saddles
(5) Numerical control apparatus totally controls a motor drive and a control shaft
(6) Antistatic ion blow apparatus
(7) Fixing tool (a turning tool and a pad cutting tool)
(8) Rotary tool (a groove milling cutter and a drill)

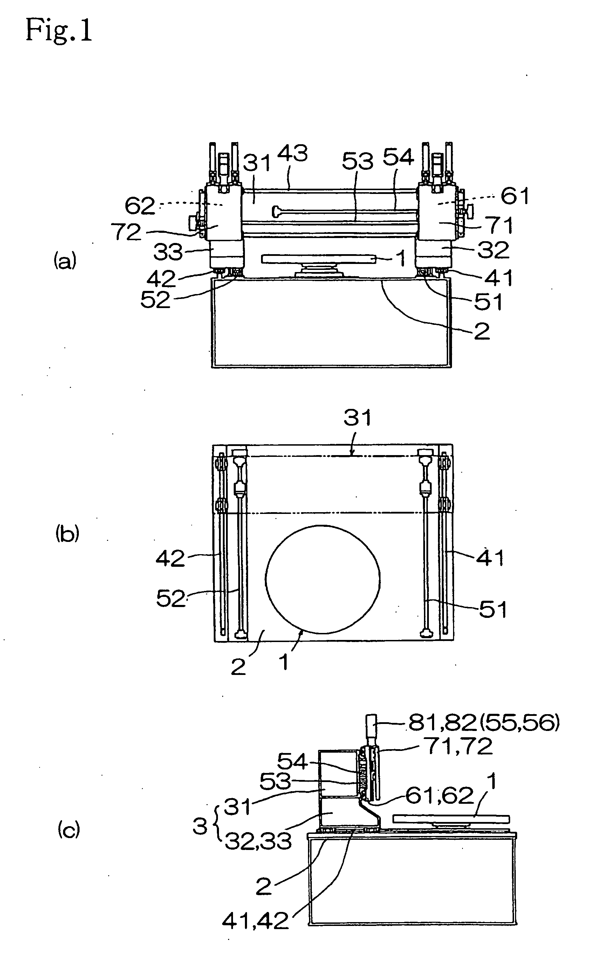

Fig.1 (a), (b) and (c) depict the overall configuration of the apparatus. In Fig.1 (a), (b) and (c), right and left columns 32 and 33 joined by a cross rail 31 are guided by horizontal first guides 41 and 42 for a horizontal and round table 1 controlled in the c-axis and a bed 2. In addition, the apparatus is provided with a gantry type column 3 controlled in the X-axis by screw shafts 51 and 52 synchronously driven, horizontal second guides 43 and 44 for commonly, movably guiding two saddles 61 and 62 placed on the cross rail 31, and screw shafts 53 and 54 for controlling the second guides in the Y-axis in parallel therewith. Furthermore, motors 81 and 82 for driving cutter holders 71 and 72 placed on each of the saddles 61 and 62 by screw shafts 55 and 56 in the Z-axis direction.

Hereinafter, each of the components will be described with reference to the drawings.

(1) Round Table

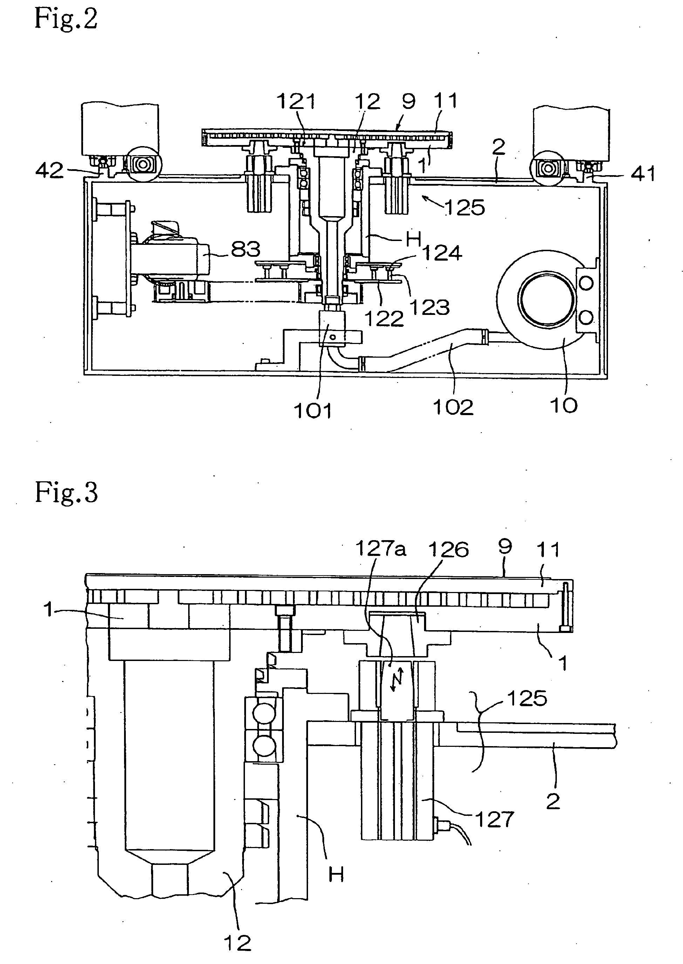

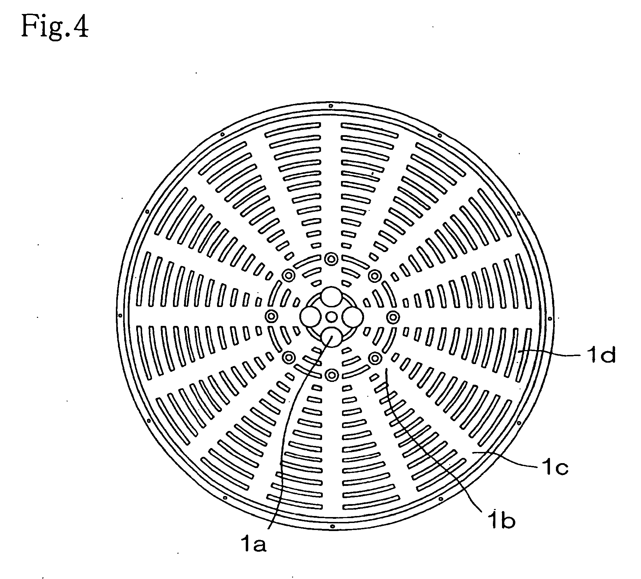

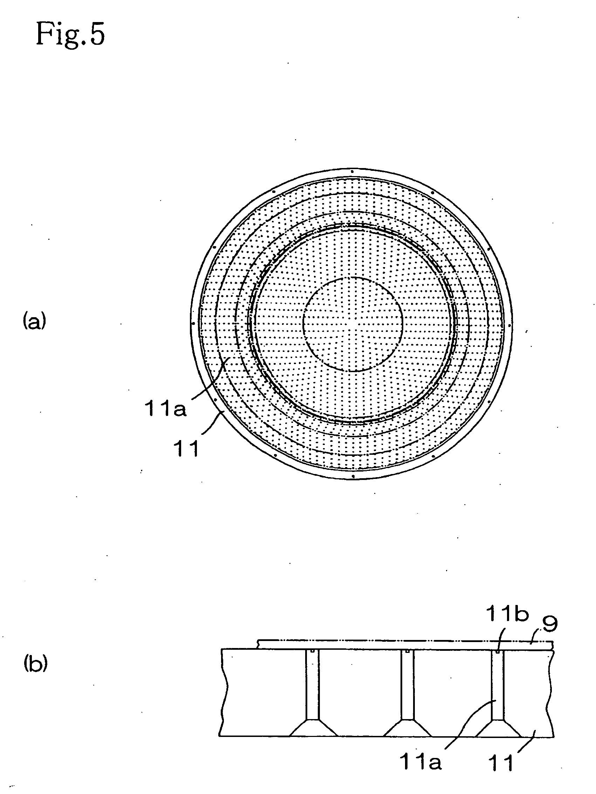

Fig.2 depicts a cross section of a round table 1 and a housing H, and an arrangement of a drive part of the round table 1 and a suction blower 10 for generating negative pressure to vacuum a polishing pad 9 on the top of the round table 1. Additionally, Fig.3 depicts a cross section of a fixing member which controls the round table 1 in the c-axis to index positions by angle and then positions the index positions of the round table 1 before a groove and the like are formed. Furthermore, Fig.4 depicts air passages cut in the round table 1 in order to uniform the suction effect. Moreover, Fig.5 depicts a vacuum plate 11 of the round table 1, in which fine grooves and through holes are disposed in order to uniformly vacuum the polishing pad 9 from the backside and to prevent the pad from being deformed by the stress in forming a groove and the like.

In Fig.2, the round table 1 in which the top is covered with the vacuum plate 11 disposed with air holes and grooves for vacuuming and fixing the polishing pad 9 and a space is formed therein, is supported by the flange surface to be fixed in one piece while the end face of a hollow center shaft 12 to communicate air through a shaft hole 121 is increased in diameter toward the upper part. The hollow center shaft 12 is fixed to the housing H as the types, dimensions and class of accuracy of an upper bean annular and a lower bean annular are selected in order to reduce runout of the outer diameter part and the end face of the round table 1. The housing H is fixed to the bed 2. In the hollow center shaft 12, a transmitting member is rotatably mounted on the shaft lower end part by shaft, and the shaft is driven by a motor 83 fixed to a seating for controlling the c-axis. It is acceptable that this drive is performed by a pulley and a belt or by transmission by gear. In addition, since the hollow center shaft 12 needs to keep suction force even during rotation, the blower 10 disposed on the bed 2 is connected to the lower end hole of the hollow center shaft 12 by a coupling 101 and a hose 102 supported by a support mounted in the seating.

In Fig.3, the round table 1 is indexed by angle at a predetermined position by the c-axis control, and fixed at the predetermined position before a groove and the like are formed. On this account, the position is detected by a sensor 124 fixed to projections 123 on a disk 122 fixed to the hollow center shaft 12 for rotation (see Fig.2). When a lattice-like groove is formed, the sensor 124 is disposed to allow the detection of a position at an angle of every 45 degrees, and the round table is fixed at the turn position at an angle of 90 degrees for processing. As a position fixing member 125, a taper-holed bush 126 for positioning is disposed at the index position on the lower surface of the round table 1, and a piston member 127 having a tapered shaft 127a at the tip end above the bed 2 is used for positioning. The piston member may be any one of a pneumatic type, hydraulic type, and electro-magnetic type.

Fig.4 depicts the top of the round table. In Fig.4, the round table 1 is preferably composed of light metals such as aluminum alloys so as to quickly activate and stop, to avoid distortion due to the use in years, and to be hardly thermally deformed. The round table 1 is disposed with plural communication holes 1a of air for communicating with the hollow center shaft. Additionally, since suction force is reduced as more apart from the center axis of the hollow center shaft toward the outer diameter direction, communication grooves 1b on the center side are processed wider in width than that of communication grooves 1c on the outer side so as to uniformly exert the suction force over the outer peripheral area. Furthermore, in the round table 1 shown in Fig.4, air communication grooves 1d are disposed on concentric circles of different radii, and they are joined to the radial communication grooves 1b and 1c.

Fig.5 depicts the vacuum plate 11. Fig.5 (a) is a top view, and Fig.5 (b) is an enlarged cross section of the sucking holes. In Fig.5 (a) and (b), the sucking holes 11a are equipped uniformly over the top of the vacuum plate 11, and the polishing pad 9 is vacuumed and fixed here. In the vacuum plate 11, the sucking holes 11a are disposed uniformly with nearly equal pitches between the holes, and the hole diameter is set properly in accordance with the pad thickness so as not to deform the polishing pad 9 by suction force. On the upper part of the vacuum plate 11, communication grooves 11b for joining the adjacent sucking holes 11a are disposed to average suction force. Additionally, when a boring unit is mounted for boring, a leak-off hole having a diameter greater than the drill diameter is generally disposed at a predetermined position of the vacuum plate 11.

(2) Gantry Type Column

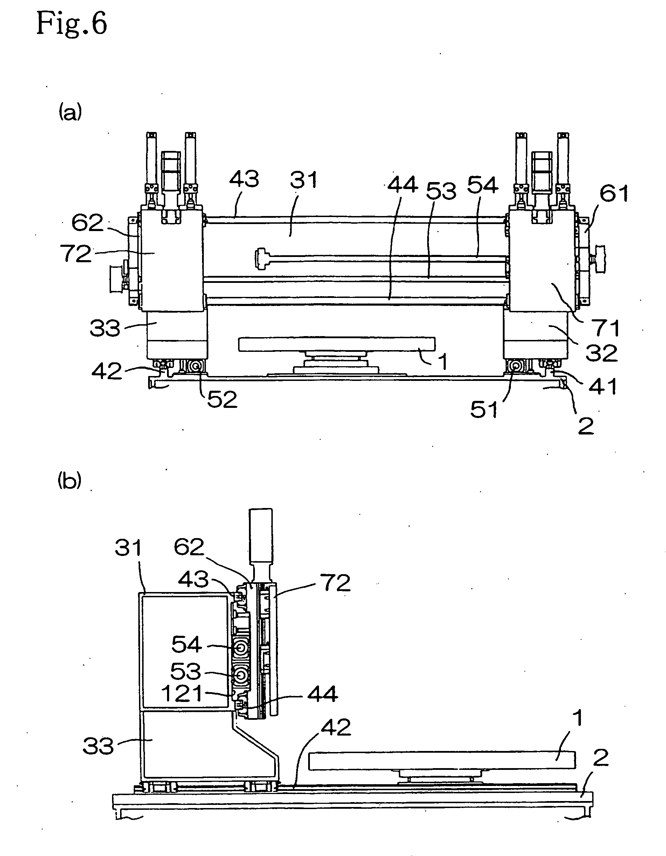

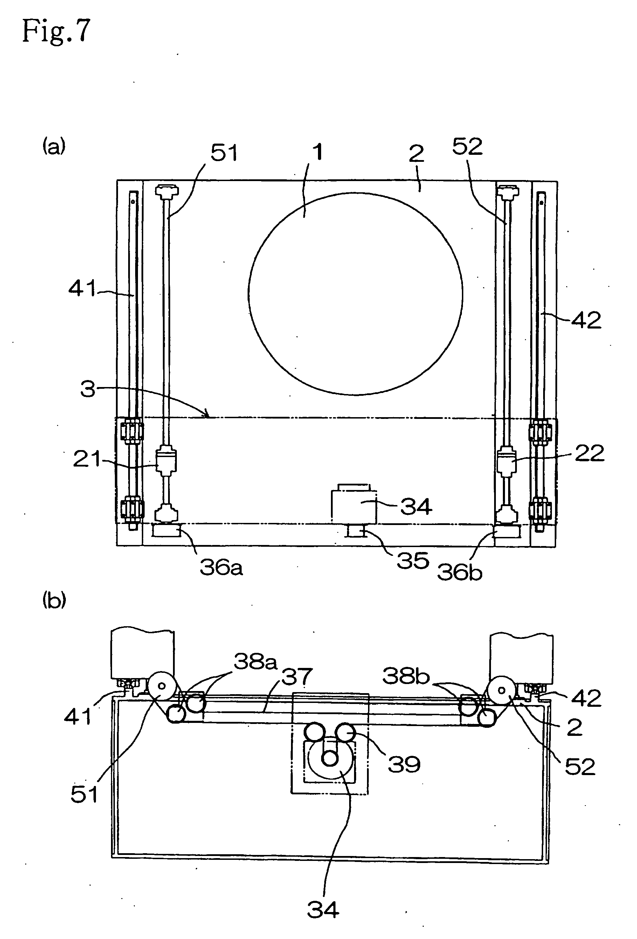

Fig.6 (a) depicts a front of the gantry type column 3 which is guided and axis-controlled by the pair of first guides 41 and 42 disposed on the bed 2 as the round table 1 in the center is sandwiched, Fig.6 (b) depicts a side of the gantry type column 3. Fig.7 (a) depicts a plan illustrating the arrangement of the pair of first guides 41 and 42 for guiding the gantry type column 3 in the X-axis direction and the pair of screw shafts 51 and 52 axis-controlled. Fig.7 (b) depicts a side of a transmission system for rotating and controlling the pair of screw shafts 51 and 52 by a single belt.

In Fig.6 (a), the gantry type column 3 is configured of the right column 32, the left column 33, and the cross rail 31, in which the right column 32 is guided by the first guide 41 on the bed 2 in parallel therewith on the outer side of the round table 1 disposed in the center part of the bed 2, and the cross rail 31 is installed between the right column 32 and the left column 33 guided by the first guide 42. Furthermore, in the side view of Fig.6 (b), the gantry type column 3 is guided by the pair of first guides 41 and 42 and is movable over the round table 1 in the X-axis direction. Moreover, the gantry type column 3 can be formed in one piece by welding or casting.

Fig.7 (a) is a plan view illustrating the top of the X-axis guides of the gantry type column 3, and Fig.7 (b) is a rear view of the apparatus showing an X-axis drive system. In Figs. 7 (a) and (b), by the screw shaft 51, ball screw and nut 21, the screw shaft 52, and ball screw and nut 22, each of them disposed in parallel with the first guides 41 and 42 on the bed 2, a pulley 35 rotatably mounted on a motor 34 by shaft and pulleys 36a and 36b mounted on the pair of screw shafts 51 and 52 by key are synchronously rotated as they are adjusted in tension by guide rollers 38a, 38b and 39 through a single belt 37 in the gantry type column 3. Driving the gantry type column 3 in the X-axis direction is feasible by synchronously controlling and driving a separate motor directly coupled to each of the screw shafts.

(3) Dual Saddles Disposed on the Cross Rail

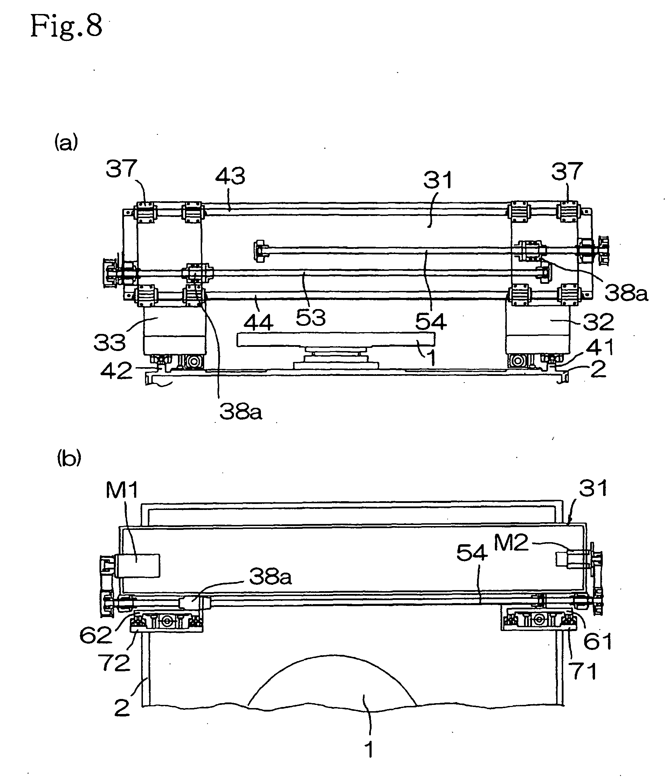

Fig.6 (a) is a front of the cross rail 31, depicting a front of the dual saddles which are guided by commonly using the pair of second guides in the Y-axis direction orthogonal to the Z- and X-axes, each position is controlled by a motor. Fig.8 (a) is a front view illustrating the arrangement of the second guides 43 and 44 disposed on the lower surface of the saddles 61 and 62 shown in Fig.6 (a) for guiding the saddles, the screw shaft 54 for driving the saddle 61, and the screw shaft 53 for driving the saddle 62, with the saddles 61 and 62 removed. Fig.8 (b) is a front view of transmitting members for a Y1-axis control motor M1 for driving the screw shaft 53 and a Y2-axis control motor M2 for driving the screw shaft 54.

In Fig.8 (a) and (b), the second guides 43 and 44 are disposed in parallel with the side of the cross rail 31. In addition, four linear bean annulars 37, each of them disposed on the lower surface of the saddles 61 and 62, guide the movement of the saddles in the Y-axis direction. Similarly on the side, the screw shafts 53 and 54 are disposed in parallel with the second guides 43 and 44, being driven by the motor (Y1-axis) M1 and the motor (Y2-axis) M2, respectively. Each rotation is screwed together with the screw shafts 53 and 54, and the Y1-axis and the Y2-axis are controlled by nuts 38a and 38b fixed to each of the lower surfaces of the saddles. Since the second guides 43 and 44 are shared, the saddles 61 and 62 are controlled so as not to interfere with each other. More specifically, when types of cutters placed on the cutter holders 71 and 72 disposed on the saddles are varied, any one of the saddle 61 and the saddle 62 is driven.

(4) Cutter Holder Placed on Each of the Right and Left Saddles

In Fig.6 (a), the right cutter holder 71 is depicted in the right saddle 61 and the left cutter holder 72 is depicted in the left saddle 62 on the sides of the cross rail 31. Here, when a rotary tool and a fixing tool are disposed in the right and left cutter holders, the same kinds of tools having different dimensions in the cutting tips can be provided in the right and left cutter holders. In the rotary tool, a groove milling cutter can be provided in one side and a drill can be provided in the other. To position the cutter is conducted in which the gantry type column 3 is controlled to move in the X-axis direction by the first guides 41 and 42, the left saddle 62 is controlled to move in the Y-axis direction by the second guides 43 and 44, the left cutter holder 72 is controlled to move in the Z-axis direction in balance with a balancer, and the left cutter holder 72 is positioned at the origin point of machining.

(5) Numerical Control Apparatus for Totally Controlling Motor Drive and the Control Shafts

The motors for controlling the c-axis, the X-axis, the Y-axis and the Z-axis in position in the machining apparatus of the polishing pad are controlled by the numerical control apparatus. The accurate, smooth positioning and the feed of cut in minute measurements are instructed, and the synchronization between the shafts is also automated in work in accordance with machining programs. Additionally, the basic patterns of the grooves to be formed on the polishing pad are stored in the numerical control apparatus beforehand, the relevant pattern is specified from the basic patterns to create the operation programs of the control shaft system, and thus automatic machining can be performed. Furthermore, total control can be performed by a sequencer instead of the numerical control apparatus. In the case of control by the sequencer, limits are imposed in acceptable accuracy in position control and feed or cut, but the configuration of the apparatus can be simplified and costs can be reduced as well.

(6) Antistatic Ion Blow Apparatus

When the polishing pad is cut, it is electrostatically charged by friction to attach cut powder to the pad. It is difficult to remove it only by air blow. Since resins and rubbers are electrostatically charged negatively, positive ions generated by corona discharge are neutralized by colliding against the polishing pad in processing to allow the cut powder to be removed in the invention. The level of the pad electrostatically charged is easily influenced by materials, hardness, machining conditions, room air temperature and humidity and the like, but the air containing ions necessary for neutralization is generally blown onto the pad based on the premise that the machining conditions are kept constant. Additionally, also in the case that cutting tools are arranged side by side to form a plurality of grooves at the same time as a multi-edged tool does, ions are uniformly blown onto the positions of generating cut powder and almost all the cut powder can be removed efficiently.

(7) Fixing Tool (Turning Tool and Pad Cutting Tool)

As the fixing tool, a single point tool and a multi-edged tool for turning are named. For forming a concentrically circular groove, both the single point tool (cutting tool) and the multi-edged tool can be used. The width of cutting part, wedge angle, rake angle, back clearance angle, and side clearance angle of the cutting tip in the cutting tool can be selected properly in accordance with materials of the polishing pad. Furthermore, when the multi-edged tool configured by forming the cutting tip as the same as the single point tool and arranging side by side is placed on the cutter holder for use, the machining efficiency is greatly enhanced. Moreover, the cutting apparatus placed on the cutter holder on the saddle is driven by a drive source comprised of a piston cylinder and the like, for example, in the Z-axis direction, and cut is done by the feed of the cutter holder.

(8) Rotary Tool Unit (Groove Milling Cutter and Drill)

The wedge angle, rake angle, width of cutting part and side-cutting-edge angle of the groove milling cutter can be selected properly in accordance with materials of the polishing pad. Although the milling cutter can be used separately to machine every single groove, a unit tool in which plural milling cutters are layered at a predetermined pitch can greatly enhance the machining efficiency. Furthermore, the drill diameter, drill length, and the number of cutting edges can be selected properly in accordance with the shape and depth of the groove. When a cone angle at the tip end of the drill is set in the range of 55 to 65 degrees, the cutting tip smoothly enters the pad. Moreover, a straight drill with no back taper in the cutting edge part of the drill main body can be easily removed. The drill can be used separately or as a multi-spindle drill unit. When it is the multi-spindle drill unit, it can process the pad efficiently.

Hereinafter, one example a method for machining concentrically annular form grooves on a polishing pad with the use of the machining apparatus described above is detailed.

A single point cutting tool or a multi-edged tool is mounted on the right cutter holder, and a polishing pad to be machined is placed on the vacuum plate of the round table. The polishing pad to be machined is preferably cut into a disk shape having the same size as that of the vacuum plate beforehand. When a groove is formed on a pad having a diameter smaller than that of the vacuum plate, an annular disk made of the same material as that of the polishing pad may be used to block unnecessary holes of the vacuum plate. Additionally, the sucking holes can be equipped only at the positions necessary to vacuum the vacuum plate, and the communication grooves of the round table can be partially blocked inside to divide the vacuuming area.

After the polishing pad is placed, the suction blower is rotated to fix the polishing pad, and a value of the number of the c-axis revolutions is inputted beforehand so that a speed of turning cut is constant in machining the inner and outer peripheries of the polishing pad. Subsequently, the gantry type column controls the X-axis position, the right saddle controls the Y1-axis position, and the right cutter holder controls the Z1 position to move the pad at the initial position. Then, input is done so that the diameter positions of concentric circles are positioned on the Y1-axis by the number of the concentric circles, and a cutting amount of the cutting tool is programmed on the Z-axis of the cutter holder. The preparation is completed by the inputs. Cutting is started, and the round table is driven at a predetermined number of revolution to begin cut by the cutting tool. A minute amount of cut is performed for predetermined times to complete the machining of a single concentrical groove.

After that, the right cutter holder and the right saddle are sequentially moved to continue the machining of the other concentrical grooves. When the pad area is wide and the number of grooves is large, a multi-edged turning tool, such as a unit tool having 10 to 30 cutting tools arranged side by side, can be used for machining efficiently. When grooves are machined in a resin pad, the removal of cut powder generated becomes a problem. However, there is the variety of cut powder generated from powder to ribbons in accordance with types of resins. Particularly, a major concern is that the pad and the cut powder are charged with high static electricity. The cut powder scatters and attaches inside the groove machined and the top of the pad, which cannot be easily collected only by air blow. On this account, preferably, an ion blow nozzle for removing cut powder is disposed near a cutting edge, and ions electrostatically charged in reversed polarity are blown onto a pad, cut powder and edge part in order to neutralize static electricity.

Fixing a polishing pad with the use of a specific machining table such a manner makes a surface roughness (Ra :of the inner surface of the grooves and the like 20 $\mu$m or less, more preferably 15 $\mu$m or less and further preferably 10 $\mu$m or less. In addition, the firmly fixing of the polishing pad by using a specific machining table leads to a groove and the like having high dimensional accuracy. The dimensional accuracy can be an accuracy of $\pm$10 % to a target value, where the target value of the groove width (the minimum dimensions in the plan direction in the case of the concave portion) is 0.1 mm. Furthermore, an accuracy of $\pm$10 % can be set to a target value, where the target value of the depth of the groove or the concave portion is 0.1 mm. Moreover, an accuracy of $\pm$10 % can be set to a target value, where the target value of a distance between grooves (the minimum distance between adjacent portions in the diameter direction in the case of the spiral groove and the concave portion) is 0.05 mm. Additionally, an accuracy of $\pm$10 % can be set to a target value, where a pitch (described below), the sum of the groove width and the distance between adjacent grooves, is 0.15 mm. Furthermore, the dimensional accuracy can be higher when a target value becomes large in any one of width, depth, distance, and pitch.

The surface roughness (Ra) is defined by the equation (1) below and is an average value calculated with three average surface roughnesses which are obtained by measuring three different field of an inner surface of the groove and the like for the polishing pad with the use of an analyzer.

$$Ra = \Sigma \mid Z - Zav \mid / N \qquad (1)$$

In the equation (1), Z is a height of the roughness curved surface, Zav is an average height of the roughness curved surface and N is a measured number.

The measuring apparatus is not particularly limited, for instance, an optical surface roughness measuring apparatus such as a three-dimensional surface structure analytic microscope, a scanning laser microscope and an electron beam surface morphology analysis apparatus, and a contact surface roughness measuring apparatus such as a probe type surface roughness meter can be used.

In addition, the dimensional accuracy can be determined as an average value that is measured by a magnifier with scale, a laser type three-dimensional measuring device and the like on each of width, depth, distance and pitch.

When an area of the polishing pad to be processed is large and a lot of grooves are to be formed, a multi-edged turning tool which is, for example, a unit tool arranged side by side with 10 to 30 cutting tools us useful to process efficiently. In this case, the use of a machining tool described below leads to a polishing pad excellent in accuracy against the prescribed dimensions.

[3] Machining tool

A milling cutter may be used for forming a groove and the like, however, a machining tool equipped with a multi-edged unit on which plural cutting edges are equipped while projecting and a holder for fixing this multi-edged unit may be also used.

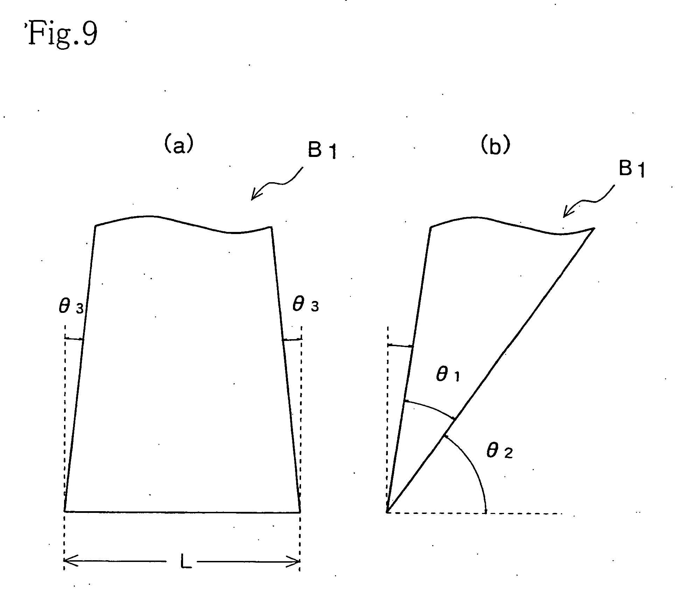

The "cutting edge" (for instance, "B1" in Fig.9) above is a portion of the multi-edged unit, which is a cutting edge that is capable of cutting and forming one groove on a polishing surface of the polishing pad by one piece of the cutting edge. The shape of this cutting edge is not particularly limited, it is preferable that the tool angle of this cutting edge ("$\theta_1$" in Fig.9) is in the range from 15 to 50 degrees, more preferably in the range from 20 to 50 degrees and further preferably in the range from 25 to 50 degrees, and it is preferable that the back-clearance angle ("$\theta_2$" in Fig.9) of the cutting edge is in the range from 65 to 20 degrees, more preferably in the range from 60 to 20 degrees and further preferably in the range from 55 to 25 degrees, and it is preferable that the side clearance angle ("$\theta_3$" in Fig.9) is in the range from 1 to 3 degrees, more preferably in the range from 1.3 to 2.7 degrees, and further preferably in the range from 1.5 to 2.5 degrees. By these settings, a groove can be formed without the inner surface of the groove being tearing off by the cutting edge, the surface roughness of the inner surface of the obtained groove can be suppressed in $20\mu m$ or less. Furthermore, a groove whose corner is not sagged and whose shape is sheer can be obtained precisely and easily when it is compared to the case where a groove is formed by metal mold. In addition, it is also preferable that both ends of the cutting edge are in contact with the polishing pad at least at the time the cutting is initiated. Therefore, the shape of edge of the cutting tip may be bent in such a way that the center portion of edge of the cutting edge is in a concave shape with respect to both ends of the edge of the cutting tip.

Moreover, the size of a cutting edge is not also particularly limited and it can be an appropriate size in correspondence with the size of the groove to be formed. The width of the cutting edge is in the range from 0.1 to 10% wider than the width of the groove as desired, more preferably in the range from 1 to 7% wider than that, and further preferably in the range from 2 to 5% wider than that. The length of the cutting edge is in the range from 10 to 300% longer than the depth of the groove as desired, more preferably in the range from 20 to 200% longer than that, and further preferably in the range from 10 to 100% longer than that.

For the purpose of forming a groove having a width of 0.1 mm or more (preferably 0.1 to 5 mm, more preferably 0.2 to 3 mm) and a depth of 0.1 mm or more (preferably 0.1 to 2.5 mm, more preferably 0.2 to 2.0 mm) in size, for instance, the width of the cutting edge ("L" in Fig.9) is preferably 0.1 mm or more, more preferably 0.15 to 5.25 mm and further preferably 0.2 to 3.15 mm, and the length of the cutting edge is preferably 0.11 mm or more, more preferably 0.11 to 7.5 mm and further preferably 0.26 to 4.0 mm.

Furthermore, a material constituting a cutting edge is not particularly limited and for example, carbon steel, alloyed steel, high speed steel, sintered hard steel thermet, sterite, ultra-high pressure sintered body, the other ceramics and the like can be used.

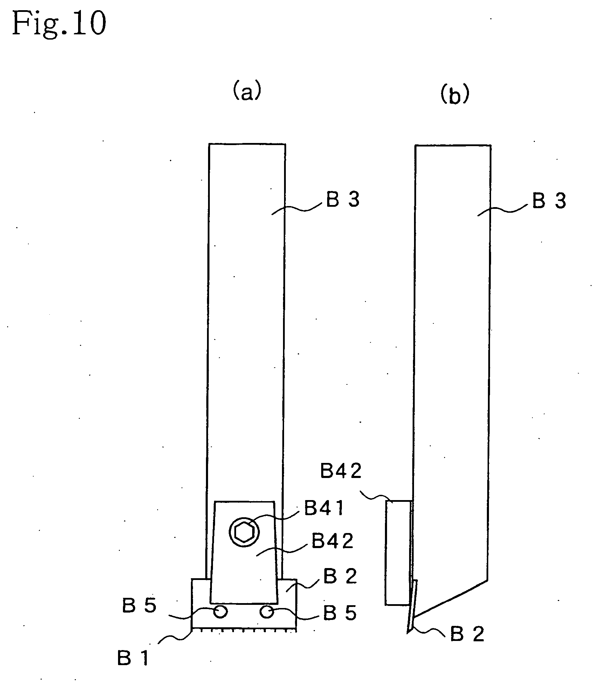

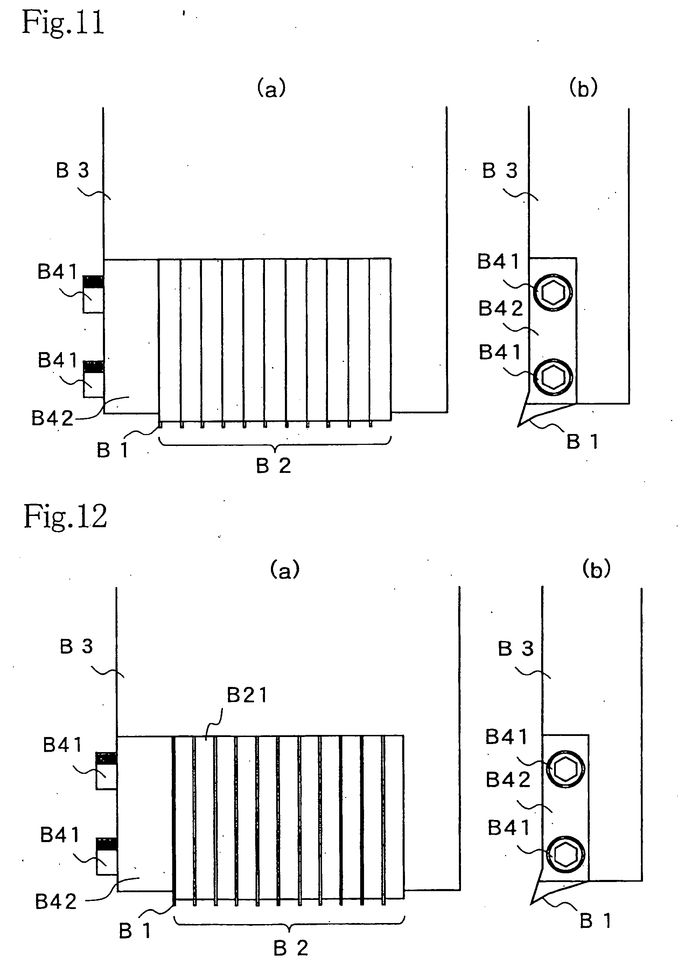

The "multi-edged unit" (for instance, "B2" in Figs. 10 to 14) above is equipped with a plurality of the cutting edges above. This multi-edged unit can be made as being in a plate shape in which the cutting edges have been integrally molded in the main body portion shown in Fig.10. Furthermore, it may be also an integrated unit using a fixing part (i.e., a bolt B41, a plate to fix B42 and the like) so that the cutting edges are aligned in the cutting direction shown in Fig.11. Upon this integration, the distance between the adjoining cutting edges can be adjusted by putting a spacer and the like between the adjacent tips shown in Fig.11. Moreover, the number of cutting edges that are provided while projecting on one multi-edged unit is not particularly limited and it may be 2 or more, and be 5 or more for example, further 10 or more, and particularly 15 or more (usually 50 or less).

Further, a distance between the adjacent cutting edges (being same as a distance between the grooves to be formed) is not particularly limited. Usually it is preferable that it is made 0.05 mm or more. In the case where the distance is less than 0.05 mm, it may be difficult that a wall between the adjacent grooves each other which was formed is maintained. Furthermore, it is more preferable that the cutting edges are provided while projecting on the multi-edged unit so that a distance between the adjacent cutting tips is in the range from 0.05 to 100 mm, and it is more preferable that the distance between the adjacent cutting tips is in the range from 0.1 to 10 mm. Similarly, a pitch of the cutting edge (i.e., the sum of a distance between the adjacent cutting tips and a width of the cutting edge) is also not particularly limited, however, it can be 0.15 mm or more for instance, more preferably in the range from 0.15 to 105 mm, further more preferably in the range from 0.3 to 13 mm and particularly preferably in the range from 0.5 to 2.2 mm. In addition, it is preferable that the cutting edges are provided while projecting on both side-ends of the multi-edged unit.

The "holder" (for instance, "B3" in Figs.11 to 13 and the like) above is to fix the multi-edged unit. The multi-edged unit which was fixed on the holder can be fixed using a fixing part (a bolt B41, a plate to fix B42 and the like) so that the multi-edged unit is capable of being removed. Owing to the capability of being removed in such a way, the groove can be stably formed by exchanging only the multi-edged unit in the case where the desired cutting performance could not be obtained due to abrasion of the cutting edge and the like, and the case where a different groove is to be formed.

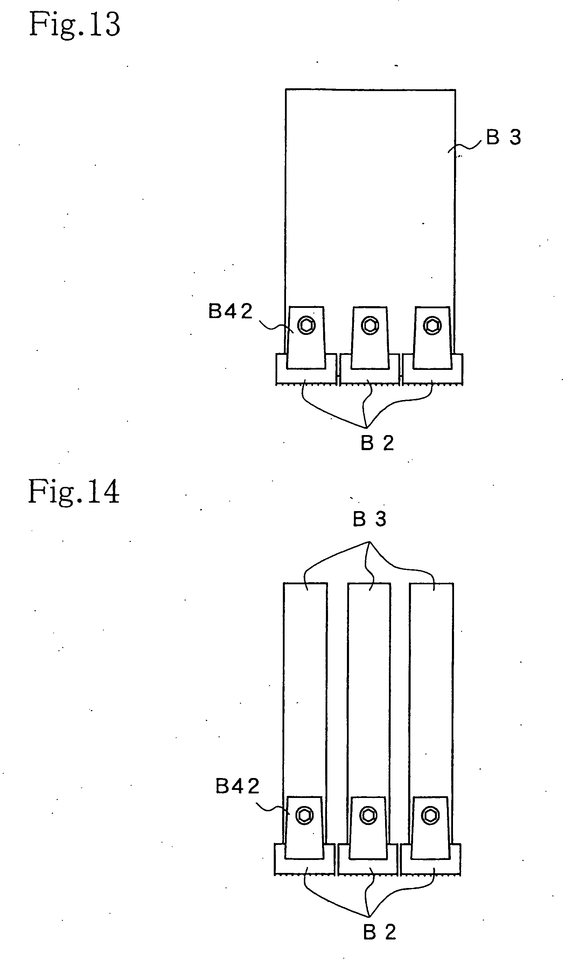

Additionally, the number of the multi-edged units which are capable of being fixed on one piece of holder is not particularly limited, and the number may be one, or it may be also 2 pieces or more. Moreover, in the case where a plurality of multi-edged units are fixed, the multi-edged units may be fixed laterally with respect to the cutting direction of the groove, these may be fixed (by superposing the multi-edged units) longitudinally with respect to the cutting direction. In the case where the multi-edged units are arranged laterally, the number of grooves that can be cut once is capable of being increased. Moreover, in the case where these are arranged longitudinally, the number of the grooves that can be cut once is capable of being increased by disposing these in such a way that the cutting edges of the respective multi-edged units are not overlapped in the cutting direction. It should be noted that in the case where these are disposed longitudinally, the distance between the multi-edged units in the longitudinal direction which is parallel with respect to the cutting direction can be adjusted by putting the spacer and the like between the respective multi-edged units. Furthermore, the number of the grooves that can be cut once is capable of being increased by mounting the multi-edged units on the machining tool by means of arranging the holders on which the multi-edged units fixed as described above have been fixed laterally and in plural rows with respect to the cutting direction shown in Fig.14.

A cutting rate by the machining tool when a groove is formed on a polishing pad is not particularly limited and may have a peripheral speed of 200 m/min and a feed rate of 0.05 mm or less per 1 round, for instance.

In addition, the machining tool makes an inner surface of the groove and the like 20 $\mu$m or less, more preferably 15 $\mu$m or less and further preferably 10 $\mu$m or less. And the machining tool forms grooves having an excellent dimensional accuracy by cutting. An accuracy of $\pm$10 % can be set to a target value, where a target value of a width of the groove is 0.1 mm, for instance. Moreover, an accuracy of $\pm$10 % can be set to a target value, where a target value of a depth of the groove is 0.1 mm. Further an accuracy of $\pm$10 % can be set to a target value, where a target value of a distance between grooves is 0.05 mm. Additionally, an accuracy of $\pm$10 % can be set to a target value, where a pitch indicated by a sum of the groove width and a distance between adjacent grooves, is 0.15 mm. The dimensional accuracy can be higher when a target value becomes large in any one of width, depth, distance and pitch.

In the polishing pad by processing methods described above, that a surface roughness of the inner surface of the groove and the like is 20 $\mu$m or less means that there is no large unevenness therein. When there is large unevenness, a particularly large convex portion (made of, for instance, cutting residue generated when the groove is formed) drops off during polishing, resulting in generating scratches. Furthermore, a foreign matter generated by compressing or the like of the dropped convex portion owing to a pressure, a friction heat and the like during polishing, a foreign matter generated by interacting a convex portion dropped off, a polishing wastage and a solid component in the slurry and the like may generate scratches in some cases. In addition, even during dressing, in some cases, these convex portions may drop off and lead to similar inconvenience.

When the surface roughness is 20 $\mu$m or less, in addition to inhibiting scratches from generating, a function as the groove and the like, a function of distributing the slurry on the polishing surface and a function of exhausting waste outside can be particularly efficiently exhibited.

According to the processing method of the present invention, a groove can be formed on a no groove-formed polishing pad that a groove is not formed. And the present method can forms additionally a groove in the case the polishing pad has not had a groove having enough functions by wearing out due to a dressing or the like. Thereby, a processed polishing pad can be used without futility.

[4] Groove, concave portion and through hole

The groove and the concave portion in the manner described above exist on a polishing surface side of the polishing pad. These groove and concave portion have functions of retaining slurry supplied during polishing and more uniformly distributing the slurry on the polishing surface. In addition, it has a function as an exhaustion path that temporarily stays waste such as polishing wastage generated during polishing and used slurry, and exhausts the waste outside of the system.

A pattern of the groove may be selected from annular form, lattice-like form, spiral form and the like, and may be dot-like concave portion. These forms may be in combinations of two or more.

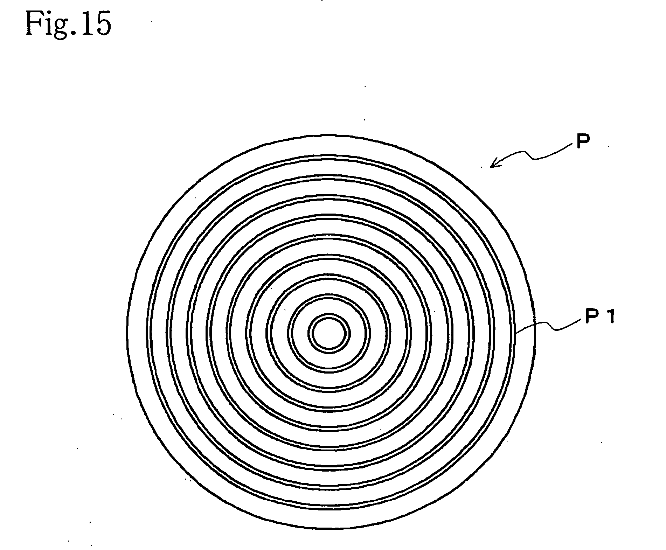

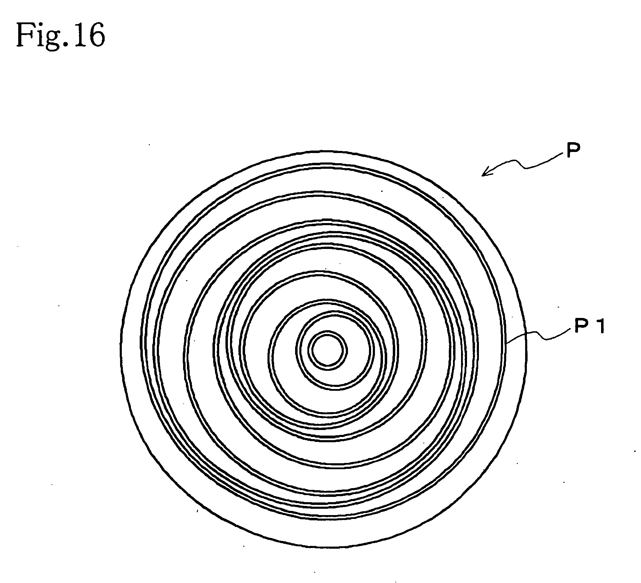

When the groove is annular form, its planar shape is not particularly limited and the shape may be a circular, a polygonal (trigonal, tetragonal, pentagonal and the like), an elliptic and the like. The number of the grooves is two or more. Furthermore, although arrangement of these grooves is not particularly limited, these may be, for instance, a concentrically arrangement (concentric circle-like and the like) with plural grooves (Fig. 15), an eccentrically arrangement with plural grooves (Fig. 16), or in such a way that plural other annular grooves are arranged inside of a part surrounded by an annular groove. Among these, one in which plural grooves are concentrically arranged is preferable, and furthermore, one in which plural grooves are concentric circularly arranged (a state in which plural circular grooves are concentrically arranged) is more preferable. The polishing pad having the concentric arrangement is superior to others in the above functions. In addition, the polishing pad having the concentric circular arrangement is more excellent in the above functions and the groove thereof can be easily formed.

On the other hand, a cross-sectional shape of the groove is not particularly limited and may be, for instance, a shape formed of flat side surfaces and a bottom surface (a length of the respective width directions of an opening side and a bottom side may be the same, or the opening side may be longer in the length than the bottom side, or the bottom side may be longer in the length than the opening side), a horseshoe shape, a V-shape and the like.

When the groove is formed in lattice, it may be formed of one continual groove or may be formed of two or more discontinuous grooves. Furthermore, a planar shape of one pattern that forms the lattice, not particularly limited, may be formed into various polygons. As the polygons, for instance, tetragons such as a square (Fig. 17), a rectangle, a trapezoid, and a lozenge (Fig. 18), a triangle (Fig. 19), a pentagon, and a hexagon can be cited.

On the other hand, when the groove is formed in lattice, a cross-sectional shape of the groove may be the same as that of the annular one.

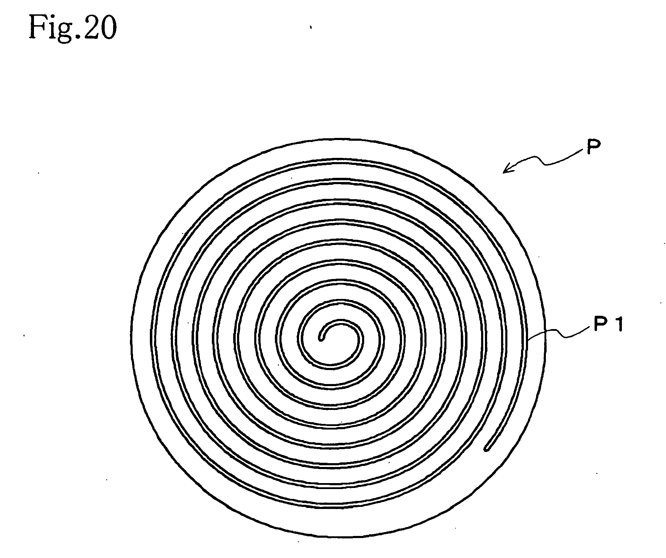

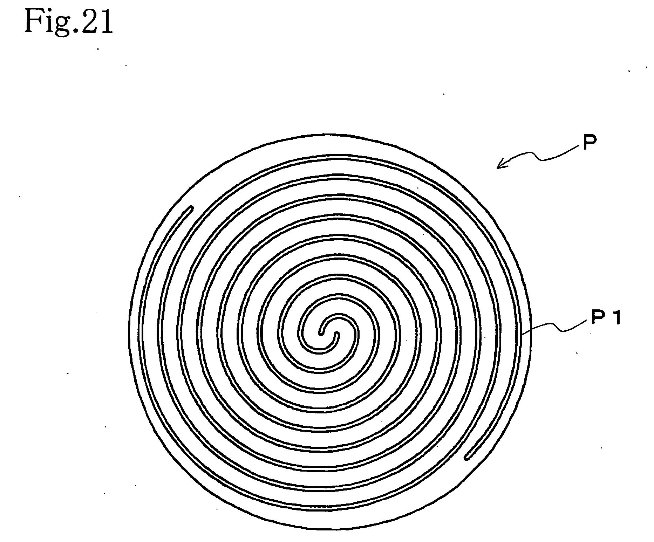

When the groove is spiral form, it may be formed of one continuous groove (Fig. 20), or may be formed of two spiral grooves whose spiral directions are different each other (Fig. 21). Furthermore, it may be formed of two spiral grooves whose spiral directions are the same, or may be formed of three or more spiral grooves whose spiral directions are the same each other or different from each other.

On the other hand, when the groove (a) is spiral form, a cross-sectional shape of the groove may be the same as that of the annular one.

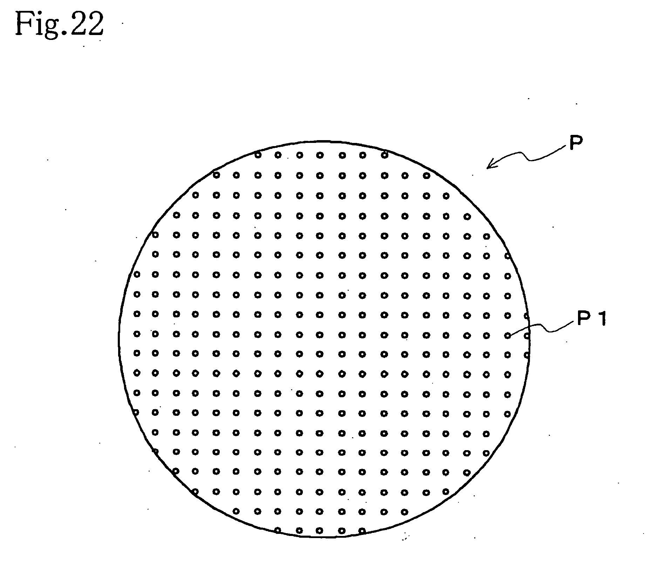

A planar shape of the concave portion is not particularly limited, but may be, for instance, a circle, a polygon (trigon, tetragon, pentagon and the like), an ellipse and the like. An arrangement of openings of the concave portion on the polishing surface is neither limited, but the openings are preferable to be uniformly arranged over an entire surface of the polishing surface. As a specific example of the polishing pad having such concave portion, one in which a concave portion having a circular planar shape are uniformly opened on the polishing surface (Fig. 22) can be cited.

On the other hand, a cross-sectional shape of the concave portion is not particularly limited, but may be, for instance, a shape formed of flat side surfaces and bottom surface (a length of the respective horizontal cross-sectional directions of an opening side and a bottom side may be the same, or the opening side may be longer in the length than the bottom side, or the bottom side may be longer in the length than the opening side.), a horseshoe shape, a V-shape and the like.

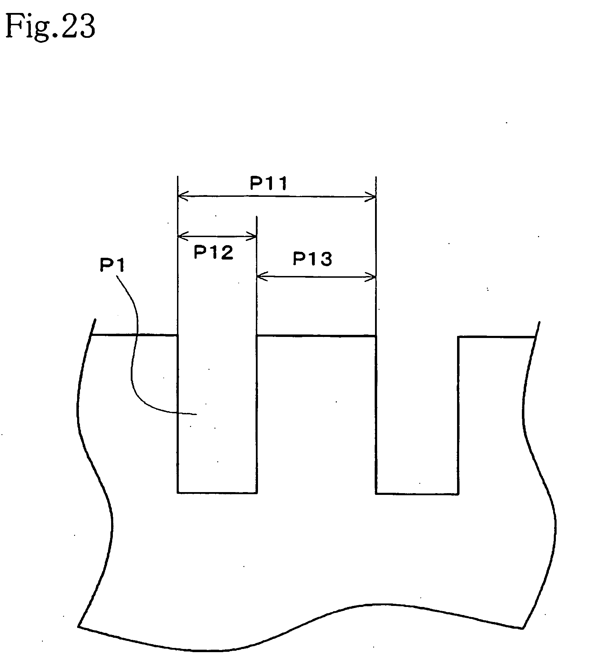

A magnitude of the groove or the concave portion is not particularly limited, but a width of the groove ("P12" in Fig. 23, and it is minimum length of the opening in the case of a concave portion.) is preferably 0.1 mm or more, more preferably in the range of from 0.1 to 5 mm, and further more preferably from 0.2 to 3 mm. It tends to be difficult to form a groove or a concave portion whose width or minimum length is less than 0.1 mm. In addition, a depth of the groove or the concave portion is preferably 0.1 mm or more, more preferably in the range of from 0.1 to 2.5 mm, and further more preferably from 0.2 to 2.0 mm. The depth of the groove or the concave portion being less than 0.1 mm is not preferable because the excessively short lifetime of the polishing pad results. Still furthermore, a smallest length between adjacent grooves or concave portions ("P13" in Fig. 23) is preferably 0.05 mm or more, more preferably in the range of from 0.05 to 100 mm, and further more preferably from 0.1 to 10 mm in the case of forming plural grooves or concave portions. It tends to be difficult to form a groove and the like whose smallest length is less than 0.05 mm. Furthermore, a pitch that is a sum of a width of the groove or the like and a distance between adjacent grooves or the like ("P11" in Fig. 23) is preferably 0.15 mm or more, more preferably in the range of from 0.15 to 105 mm, further more preferably from 0.3 to 13 mm, and particularly from 0.5 to 2.2 mm.

Each of the preferable ranges can combine with other preferable ranges. That is, it is preferable, for instance, for the width or the like to be 0.1 mm or more, for the depth 0.1 mm or more, and for the smallest length 0.05 mm or more; more preferable for the width in the range of from 0.1 mm to 5 mm, for the depth from 0.1 to 2.5 mm, and for the smallest length from 0.05 to 100 mm; and further more preferable for the width from 0.2 mm to 3 mm, for the depth from 0.2 to 2.0 mm, and for the smallest length from 0.1 to 10 mm.

On the other hand, the through hole has an opening on the both sides of the polishing surface side and the opposite side. A planar shape and a cross-sectional shape of the through hole may be the same as the case of the concave portion described above. For the cross-sectional shape, a length of the respective horizontal directions of one opening side and the other opening side may be the same, or the length of the polishing surface side may be longer, or the length of the opposite surface side may be longer. A smallest length of the opening, and a minimum distance between adjacent through holes and a pitch in the case of forming plural through holes, are the same as the case of the concave portion described above.

Preferable ranges of the smallest length of the opening and the minimum distance between adjacent through holes may be a combination of each of the preferable ranges. That is, it is preferable, for instance, for the smallest length of the opening to be 0.1 mm or more, for the minimum distance between adjacent through holes 0.05 mm or more; more preferable for the smallest length of the opening in the range of from 0.1 to 5 mm, for the minimum distance between adjacent through holes 0.05 to 100 mm; and further more preferably for the smallest length of the opening in the range of from 0.2 to 3 mm, for the minimum distance between adjacent through holes 0.1 to 10 mm.

[5] Multi-layer polishing pad

The polishing pad processed as above may comprise a supporting layer on a non-polishing surface side of the polishing pad to a multi-layer polishing pad and this multi-layer polishing pad can be used. A mode of the multi-layer polishing pad includes (1) one provided with a polishing layer having a groove whose planar shape opened to the polishing surface side is annular form, lattice-like form, spiral form and the like, or a concave portion, and a supporting layer laminated on a non-polishing surface side of the polishing layer, (2) one provided with a polishing layer having a through hole whose planar shape opened to the polishing surface side is circular or the like, and a supporting layer laminated on a non-polishing surface side of the polishing layer, (3) one provided with a polishing layer having at least two parts selected from a groove, a concave portion and a through hole that is opened to the polishing surface side each and a supporting layer laminated on a non-polishing surface side of the polishing layer, and the like.

As the polishing layer, the polishing pad described above can be used.

This polishing layer is adhered or bonded to other layer such as a supporting layer on the opposite surface side, and a slurry does not outflow through the through holes without serving to polishing.

In addition, the supporting layer is not particularly limited in the characteristics, and it is preferable to be softer than the polishing layer. When the supporting layer is made softer, even when a thickness of the polishing layer is thin (for instance, 5 mm or less), the polishing layer is inhibited from rising or a surface of the polishing layer from curving during polishing; resulting in stable polishing. The hardness of the supporting layer is preferably 90 % or less of that of the polishing layer, more preferably 80 % or less, particularly 70 % or less, and normally 10 % or more.

Furthermore, the Shore D hardness is preferably 70 or less, more preferably 60 or less, further more preferably 50 or less and generally 1 or more.

In addition, the supporting layer may be a porous body (foamed body) or a non-porous body. Furthermore, its planar shape is not particularly limited, and may be the same as the polishing layer or different from the polishing layer. As a planar shape of the supporting layer, for instance, a circle, a polygon (tetragon and the like) and the like can be adopted. Furthermore, a thickness of the supporting layer is neither particularly limited, but it can be made, for instance, in the range of from 0.1 to 5 mm (more preferably in the range of from 0.5 to 2 mm).

A material that constitutes the supporting layer is not particularly limited. In view of easiness to form a predetermined shape and state and capability of endowing appropriate elasticity, an organic material is preferably used. As the organic material, the organic materials that constitute the water-insoluble matrix in the polishing pad above can be applied. However, the organic material that constitutes the supporting layer may be a crosslinked polymer or a non-crosslinked polymer.

The multi-layer polishing pad may be provided with only one supporting layer or two or more layers. In addition, the supporting layer and the polishing layer may be directly laminated or may be laminated through another layer. Furthermore, the supporting layer may be adhered to the polishing layer or other layer with an adhesive, an adhesive material (bond layer composed of adhesive tape and the like) and the like, or may be integrally bonded thereto by partially fusing.

The polishing pad and the multi-layer polishing pad may be provided with a window and the like for end-point detection. As this window, a part whose transmittance of a light at a wavelength between 100 and 300nm is 0.1 % or more (preferably 2 % or more), or whose integrated transmittance in a wavelength range between 100 and 3000nm is 0.1 % or more (preferably 2 % or more), for instance, when a thickness is 2mm may be used.

Brief Description of the Drawings

Fig.1 depicts total configuration of a machining apparatus, (a) is a front view, (b) is a plan view, and (c) is a side view.

Fig.2 is a schematic diagram illustrating a cross section of a round table 1 and a housing 3, and the arrangement of a drive part of the round table 1 and a suction blower 10 for generating negative pressure for vacuuming a polishing pad 9 on the top of the round table 1.

Fig.3 is a schematic diagram illustrating a cross section of a fixing member in which the round table 1 is controlled in the c-axis to index positions by angle and then the index positions of the round table 1 are positioned before a groove is machined.

Fig.4 is a plan view illustrating air passages cut in the round table 1.

Fig.5 depicts a vacuum plate 11 of the round table 1, (a) is a plan view, and (b) is a schematic diagrams illustrating an enlarged sucking hole 11a and the like.

Fig. 6 depicts a gantry type column 3 which is guided by a pair of first guides 41 and 42 disposed on a bed 2 to be axis-controlled as the round table 1 is sandwiched, (a) is a front view, and (b) is a side view.

Fig.7 (a) is a plan view illustrating the arrangement of the pair of first guides 41 and 42 for guiding the gantry type column 3 in the X-axis direction and a pair of screw shafts 51 and 52 axis-controlled, and (b) is a side view of a transmission system for rotating and controlling the pair of screw shafts 51 and 52 by a single belt; and

Fig.8 (a) is a front view illustrating the arrangement of second guides 43 and 44 for guiding saddles 61 and 62, a screw shaft 54 for driving the saddle 61, and a screw shaft 53 for driving the saddle 62 with the saddles 61 and 62 removed, and (b) is a front view illustrating transmitting members for a Y1-axis control motor 35 for driving the screw shaft 53 and a Y2-axis control motor 36 for driving the screw shaft 54.

Fig.9 is an explanatory diagram for each angle of a cutting edge in processing of the present invention.

Fig.10 is an explanatory diagram showing one example of a multi-edged unit, a holder and the like used in processing of the present invention, (a) is a schematic front view and (b) is a schematic side view.

Fig.11 is an explanatory diagram showing another example of a multi-edged unit, a holder and the like used in processing of the present invention, (a) is a schematic front view and (b) is a schematic side view.

Fig.12 is an explanatory diagram showing other example of a multi-edged unit, a holder and the like used in processing of the present invention, (a) is a schematic front view and (b) is a schematic side view.

Fig.13 is a schematic diagram showing one example of a multi-edged unit, a holder and the like used in processing of the present invention.

Fig.14 is an explanatory diagram showing an arrangement of the holder used in processing of the present invention.

Fig.15 is a plan view showing a polishing pad having grooves in concentrically annular formed on the polishing surface side.

Fig.16 is a plan view showing a polishing pad having grooves in eccentrically arranged annular formed on the polishing surface side.

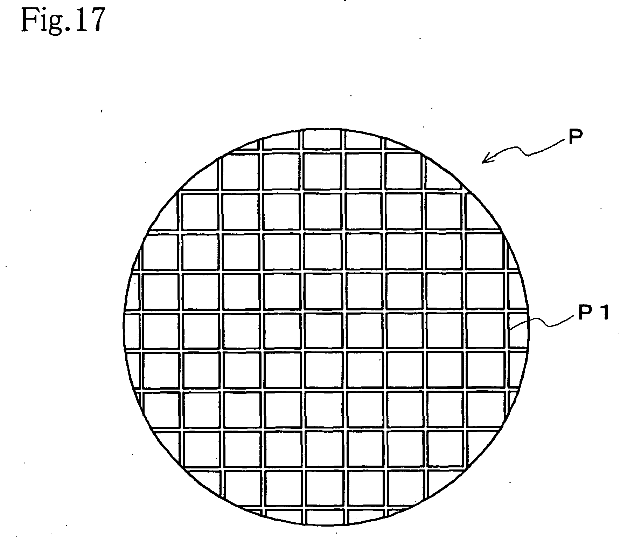

Fig.17 is a plan view showing a polishing pad having lattice-like grooves whose plan form is square formed on the polishing surface side.

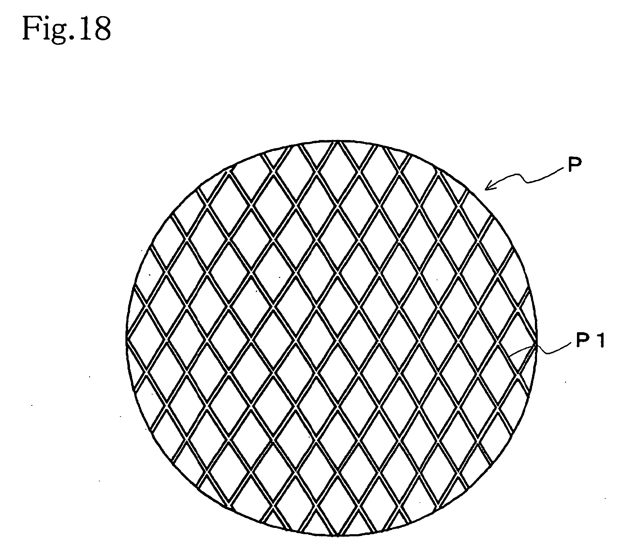

Fig.18 is a plan view showing a polishing pad having lattice-like grooves whose plan form is lozenge formed on the polishing surface side.

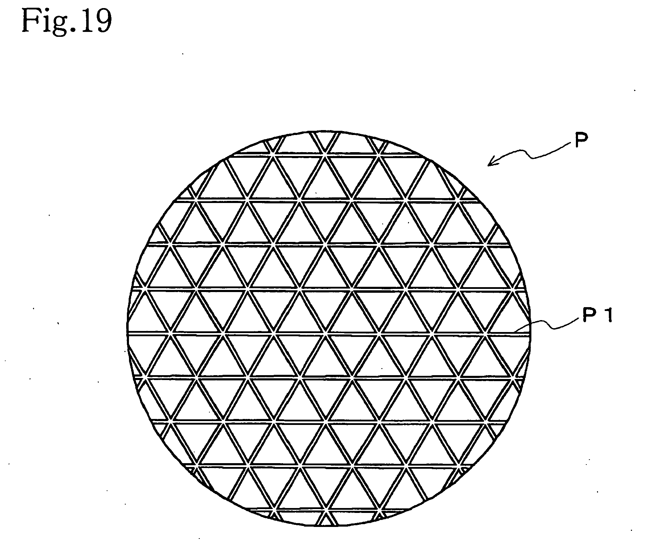

Fig.19 is a plan view showing a polishing pad having lattice-like grooves whose plan form is triangle formed on the polishing surface side.

Fig.20 is a plan view showing a polishing pad having a spiral groove formed of one continuous on the polishing surface side.

Fig.21 is a plan view showing a polishing pad having two spiral groove whose spiral directions are different each other formed on the polishing surface side.

Fig.22 is a plan view showing a polishing pad having a concave portion whose plan form is circular formed and uniformly opened on the polishing surface side.

Fig.23 is a schematic diagram of a partial cross section including a groove, a concave portion and a through hole of the polishing pad.

Explanation of Reference Characters

1; round table, 1a; air passage, 1b; communication groove on the center side, 1c; communication groove on the outer side, 1d; air communication groove, 11; vacuum plate, 11a; sucking hole, 11b; communication groove, 12; hollow center shaft, 121; shaft center hole, 122; disk, 123; projection, 124; sensor, 125; position fixing member, 126; taper-holed bush, 127a; tapered shaft, 127; piston member, 2; bed, 21 and 22; ball and nut, 3; gantry type column, 31;

cross rail, 32 and 33; right and left columns, 34; motor, 35; pulley, 36a and 36b; pulley, 37; belt, 38a and 38b; nut, 39; guide roller, M1 and M2; motor, 41 and 42; horizontal first guide, 43 and 44; horizontal second guide, 51 and 52; screw shaft synchronously driven, 53, 54, 55 and 56; screw shaft, 61 and 62; two saddles, 71 and 72; cutter holder, 81 and 82; drive motor, 83; c-axis control motor, H; housing, 9; polishing pad, 10; suction blower, 101; coupling, 102; hose, B1; cutting edge, B2; multi-edged unit, B3; holder, B41; bolt (fixing part), B42; plate to fix (fixing part), B5; hooking pin, $\theta_1$; tool angle, $\theta_2$; back clearance angle, $\theta_3$; side clearance angle of the cutting edge which is in contact with the inner wall of the groove, P; polishing pad, P1; groove, P11; pitch, P12; width of groove, or minimum length of opening of concave portion or through hole, P13; minimum length of adjacent grooves, concave portions or through holes.

Best Mode for Carrying out the Invention

The present invention is specifically explained below by way of Example.

Example 1

70 parts by mass of non-crosslinked 1,2-polybutadiene (Trade name "JSR RB830" manufactured by JSR Corp.), 30 parts by mass of non-crosslinked ethylene-vinyl acetate copolymer (Trade name, "Ultrathene 630" manufactured by Tosoh Corp.), and 40 parts by mass of β-cyclodextrin (Trade name "Dexipearl β-100" manufactured by Bio Research Corporation of Yokohama, having average particle diameter of 20 $\mu$m) as a water-soluble particle were kneaded with the use of a biaxial extruder controlled at a temperature of 160°C. Subsequently, 1.0 part by mass of an organic peroxide (Trade name "Percumyl D-40" manufactured by NOF Corp.) was added and further kneaded, and the mixed product was extruded into a mold. After that, it underwent a crosslinking process of holding it at a temperature of 170°C for 18 minutes, obtaining a polishing pad, 60 cm in diameter and 3 mm in thickness. Then, plural annular grooves were formed concentrically on the polishing surface of the polishing pad according to the method described in [2], where the average value of the groove width was 0.5 mm, the average value of the groove depth was 0.5 mm, and the average value of the pitch was 4 mm.

The surface roughness of the inner surface of this groove was 4.1 $\mu$m, and variations in the surface roughness were also small. Additionally, the dimensional accuracy was ±6 % in width, ±5 % in depth, and ±5 % in pitch, being excellent. The surface roughness was measured with a three-dimensional surface structure analytic microscope (Trade name "Zygo New View 5032", manufactured by CANON Inc.). The following is the same.

Furthermore, the polishing performance of the polishing pad having grooves was evaluated as follows:

(1) Removal rate and existence of scratches

The polishing pad was mounted on a surface plate of a polishing apparatus (Model name "Lapmaster LM-15" manufactured by SFT Corp.), and $SiO_2$ film wafer was polished for two minutes under a condition of a number of revolution of 50rpm and a flow rate of 100 cc/min of a chemical mechanical polishing slurry (Trade name "CMS 1101" manufactured by JSR Corp.) that was diluted to three times. A removal rate and an existence of scratches were evaluated. The film thicknesses before and after polishing were measured by an optical thickness meter, and the removal rate was calculated from these film thicknesses. In addition, scratches were confirmed by observing the polished surface of the $SiO_2$ film wafer after polishing with an electron microscope. As the result, the removal rate was 350 nm/min and scratches were hardly observed.

(2) Evaluation of dishing

A semiconductor wafer (Trade name "SKW-7" manufactured by SKW Associates, Inc.) was polished under the condition below, and a dishing was measured by a topography measuring apparatus (Model name "P-10" manufactured by KLA-Tencor Corp.). As the result, the dishing was 70 nm, and the polished surface was excellent in flatness.
Slurry; "CMS 1101" (manufactured by JSR Corp.)
CMP apparatus; "EPO112" (manufactured by Ebara Corp.)
Slurry flow rate; 200 ml/min
Polishing load; 400 g/cm$^2$
Number of revolution of the surface plate; 70 rpm
Number of revolution of the head; 70 rpm
Removal rate; 400 nm/min
Polishing time; 5.75 min (15 % over polished)

Example 2

A polishing pad having the same size was produced similarly to Example 1, and plural annular grooves were formed concentrically on the polishing surface of the polishing pad according to the method described in [2], where the average value of the groove width was 0.5 mm, the average value of the groove depth was 1 mm, and the average value of the pitch was 1 mm.

The surface roughness of the inner surface of the groove was 5.2 $\mu$m, and variations in the surface roughness were also small. Additionally, the dimensional accuracy was $\pm 4$ % in width, $\pm 5$ % in depth, and $\pm 5$ % in pitch, being excellent. Furthermore, a removal rate, an existence of scratches and a dishing were evaluated similarly to Example 1. As the result, the removal rate was 300 nm/min, scratches were hardly observed, and dishing was 60 nm; the polished surface was excellent in flatness.

Example 3

80 parts by mass of non-crosslinked ethylene-vinyl acetate copolymer (Trade name, "Ultrathene 630" manufactured by Tosoh Corp.), 20 parts by mass of non-crosslinked 1,2-polybutadiene (made by JSR Corporation, product name, JSR RB830), and 100 parts by mass of β-cyclodextrin (Trade name "Dexipearl β-100" manufactured by Bio Research Corporation of Yokohama, having average particle diameter of 20 $\mu$m) as a water-soluble particle were kneaded with the use of a biaxial extruder controlled at a temperature of 160°C. Subsequently, 0.5 parts by mass of an organic peroxide (Trade name "Percumyl D-40" manufactured by NOF Corp.) was added and further kneaded, and the mixed product was extruded into a mold controlled at a temperature of 170°C. It underwent a crosslinking process of holding it at a temperature of 170°C for 18 minutes, obtaining a polishing pad, 60 cm in diameter and 3 mm in thickness. Then, plural annular grooves were formed concentrically on the polishing surface of the polishing pad according to the method described in [2], where the average value of the groove width was 0.5 mm, the average value of the groove depth was 0.5 mm, and the average value of the pitch was 4 mm.

The surface roughness of the inner surface of the groove was 3.8 $\mu$m, and variations in the surface roughness were also small. Additionally, the dimensional accuracy was $\pm 3$ % in width, $\pm 4$ % in depth, and $\pm 4$ % in pitch, being excellent. Furthermore, a removal rate, an existence of scratches and a dishing were evaluated similarly to Example 1. As the result, the removal rate was 400 nm/min, scratches were hardly observed, and dishing was 55 nm; the polished surface was excellent in flatness.

Example 4

A polishing pad having the same size was produced similarly to Example 3, and plural annular grooves were formed concentrically on the polishing surface of the polishing pad according to the method described in [2], where the average value of the groove width was 0.5 mm, the average value of the groove depth was 1 mm, and the average value of the pitch was 1 mm.

The surface roughness of the inner surface of the groove was 5.5 $\mu$m, and variations in the surface roughness were also small. Additionally, the dimensional accuracy was $\pm 3$ % in width, $\pm 5$ % in depth, and $\pm 5$ % in pitch, being excellent. Furthermore, a removal rate, an existence of scratches and a dishing were evaluated similarly to Example 1. As the result, the removal rate was 350 nm/min, scratches were hardly observed, and dishing was 60 nm; the polished surface was excellent in flatness.

Comparative Example 1

Plural annular grooves were formed concentrically on the polishing surface of a commercially available polishing pad made of foamed polyurethane (Trade name "IC1000" manufactured by Rodel Nitta Co.) according to the method described in [2], where the average value of the groove width was 0.25 mm, the average value of the groove depth was 0.4 mm, and the average value of the pitch was 1.5 mm.

The surface roughness of the inner surface of the groove was great as 355 $\mu$m, and variations in the surface roughness were significantly great as well. Additionally, the dimensional accuracy was $\pm 15$ % in width, $\pm 20$ % in depth, and $\pm 12$ % in pitch, being inferior. Furthermore, a removal rate, an existence of scratches and a dishing were evaluated similarly to Example 1. As the result, the removal rate was 350 nm/min, many scratches were observed, and dishing was 150 nm; the polished surface was inferior in flatness as well.

Example 5

The polishing pad produced in Example 1 was processed by use of a machining tool to which plural holders having a multi-edged unit shown in Fig.10 is attached with the same distance between the cutting tips. The multi-edged unit whose tool angle $\theta_1$ of the fixed cutting edge is 45 degree, whose back clearance angle $\theta_2$ is 30 degree, whose side clearance angle $\theta_3$ of the cutting edge which is in contact with the inner wall of the groove is 2 degree, whose width of the cutting edge L is 0.52 mm, whose distance between adjacent cutting tips is 3.48 mm, and whose length of the cutting edge is 5 mm was used. With this machining tool, plural annular grooves were formed concentrically on the polishing surface of the above polishing pad at the same time, where the average value of the groove width was 0.5 mm, the average value of the groove depth was 0.5 mm, and the average value of the pitch was 4 mm.

The surface roughness of the inner surface of this groove was 4.1 $\mu$m, and variations in the surface roughness were also small. Additionally, the dimensional accuracy was $\pm6$ % in width, $\pm5$ % in depth, and $\pm5$ % in pitch, being excellent.

Next, a removal rate, an existence of scratches and a dishing were evaluated similarly to Example 1. As the result, the removal rate was 350 nm/min, scratches were hardly observed, and dishing was 70 nm; the polished surface was excellent in flatness.

Example 6

The polishing pad produced in Example 1 was processed similarly to Example 5 to form concentric grooves. The multi-edged unit whose tool angle $\theta_1$ of the fixed cutting edge is 30 degree, whose back clearance angle $\theta_2$ is 50 degree, whose side clearance angle $\theta_3$ of the cutting edge which is in contact with the inner wall of the groove is 2 degree, whose width of the cutting edge L is 0.52 mm, whose distance between adjacent cutting tips is 0.48 mm, and whose length of the cutting edge is 3 mm was used. The average value of the groove width of the formed grooves was 0.5 mm, the average value of the groove depth was 1 mm, and the average value of the pitch was 1 mm.

The surface roughness of the inner surface of this groove was 5.2 $\mu$m, and variations in the surface roughness were also small. Additionally, the dimensional accuracy was $\pm4$ % in width, $\pm5$ % in depth, and $\pm5$ % in pitch, being excellent. Further, a removal rate, an existence of scratches and a dishing were evaluated similarly to Example 1. As the result, the removal rate was 300 nm/min, scratches were hardly observed, and dishing was 60 nm; the polished surface was excellent in flatness.

Example 7

The polishing pad produced in Example 3 was processed similarly to Example 5 to form concentric grooves. The multi-edged unit whose tool angle $\theta_1$ of the fixed cutting edge is 30 degree, whose back clearance angle $\theta_2$ is 45 degree, whose side clearance angle $\theta_3$ of the cutting edge which is in contact with the inner wall of the groove is 2 degree, whose width of the cutting edge L is 0.52 mm, whose distance between adjacent cutting tips is 3.48 mm, and whose length of the cutting edge is 5 mm was used. The average value of the groove width of the formed grooves was 0.5 mm, the average value of the groove depth was 0.5 mm, and the average value of the pitch was 0.5 mm.

The surface roughness of the inner surface of this groove was 3.8 $\mu$m, and variations in the surface roughness were also small. Additionally, the dimensional accuracy was $\pm4$ % in width, $\pm4$ % in depth, and $\pm4$ % in pitch, being excellent. Further, a removal rate, an existence of scratches and a dishing were evaluated similarly to Example 1. As the result, the removal rate was 400 nm/min, scratches were hardly observed, and dishing was 55 nm; the polished surface was excellent in flatness.

Example 8

The polishing pad produced in Example 3 was processed similarly to Example 5 to form concentric grooves. The multi-edged unit whose tool angle $\theta_1$ of the fixed cutting edge is 30 degree, whose back clearance angle $\theta_2$ is 50 degree, whose side clearance angle $\theta_3$ of the cutting edge which is in contact with the inner wall of the groove is 2 degree, whose width of the cutting edge L is 0.52 mm, whose distance between adjacent cutting tips is 0.48 mm, and whose length of the cutting edge is 3 mm was used. The average value of the groove width of the formed grooves was 0.5 mm, the average value of the groove depth was 1 mm, and the average value of the pitch was 1 mm.

The surface roughness of the inner surface of this groove was 5.5 $\mu$m, and variations in the surface roughness were also small. Additionally, the dimensional accuracy was $\pm3$ % in width, $\pm5$ % in depth, and $\pm5$ % in pitch, being excellent. Further, a removal rate, an existence of scratches and a dishing were evaluated similarly to Example 1. As the result, the removal rate was 350 nm/min, scratches were hardly observed, and dishing was 60 nm; the polished surface was excellent in flatness.

Comparative Example 2

The polishing pad used in Comparative Example 1 was processed similarly to Example 5 to form concentric grooves. The multi-edged unit whose tool angle $\theta_1$ of the fixed cutting edge is 60 degree, whose back clearance angle $\theta_2$ is 20 degree, whose side clearance angle $\theta_3$ of the cutting edge which is in contact with the inner wall of the groove is 2 degree, whose width of the cutting edge L is 0.26 mm, whose distance between adjacent cutting tips is 1.24 mm, and whose length of the cutting edge is 3 mm was used. The average value of the groove width of the formed grooves was 0.25 mm, the average value of the groove depth was 0.4 mm, and the average value of the pitch was 1.5 mm.
The surface roughness of the inner surface of the groove was great as 355 $\mu$m, and variations in the surface roughness were significantly great as well. Additionally, the dimensional accuracy was $\pm$15 % in width, $\pm$20 % in depth, and $\pm$12 % in pitch, being inferior. Furthermore, a removal rate, an existence of scratches and a dishing were evaluated similarly to Example 1. As the result, the removal rate was 350 nm/min, many scratches were observed, and dishing was 150 nm; the polished surface was inferior in flatness as well.

Advantage of the Invention

According to the present invention, a groove, a concave portion, a through hole and the like can be easily and accurately formed on the polishing surface of a polishing pad, and surface roughness of the inner surface of these grooves and the like can be small.
In addition, in the case of forming a groove and the like after fixing the polishing pad on one surface side of a specific machining table, a groove having a high dimensional accuracy and a uniform cross-sectional shape can be obtained.
Furthermore, in the case of using a cutting edge having a specific tool angle, back clearance angle and side clearance angle of the cutting edge which is in contact with the inner wall of the groove, in the case of using a multi-edged unit having a specific distance between adjacent cutting tips, and in the case of using a multi-edged unit which is provided while projecting on the both edges of a side of the multi-edged unit, grooves can be formed efficiently and reliably. The preferred is the case of concentrically annular form.
According to the present polishing pad for semiconductor wafer, a polished surface excellent in planarity can be obtained when a semiconductor wafer is polished. Industrial Applicability
The polishing pad for semiconductor wafer of the present invention is particularly useful in producing process of a semiconductor device. And the polishing pad can be used in for instance, in a STI process, a damascene process for forming a wiring of metal such as Al and Cu, a damascene process for forming a via plug with the use of Al, Cu, W and the like, a dual damascene process for forming these metal wirings and via plugs at the same time, a polishing process of an interlayer insulation film (oxide film, Low-k, BPSG and the like), a polishing process of a nitride film (TaN, TiN and the like), a polishing process of a polysilicon, a bare silicon and the like.

**Claims**

1.  A method of processing a polishing surface of a polishing pad for semiconductor wafers comprising
    a water-insoluble matrix containing a crosslinked polymer and
    a water-soluble particle dispersed in said water-insoluble matrix,
    the method consisting in forming a groove having an inner surface roughness of 20 $\mu$m or less with the use of a machining tool having a multi-edged unit equipped with plural cutting edges
    **characterized in that**
    said polishing pad for semiconductor wafers is placed on one surface side of a machining table having a sucking hole,
    said polishing pad for semiconductor wafers is fixed on the one surface side of said machining table by vacuum sucking said polishing pad from the other surface of said machining table, and
    the cutting edges have a width which is in a range of 0.1 to 10% wider than a width of said groove.

2.  A method of processing a polishing surface of a polishing pad for semiconductor wafers comprising
    a water-insoluble matrix containing a crosslinked polymer and
    a water-soluble particle dispersed in said water-insoluble matrix,
    the method consisting in forming a groove having an inner surface roughness of 20 $\mu$m or less with the use of a machining tool having a multi-edged unit equipped with plural cutting edges
    **characterized in that**
    said polishing pad for semiconductor wafers is placed on one surface side of a machining table having a sucking hole,
    said polishing pad for semiconductor wafers is fixed on the one surface side of said machining table by vacuum sucking said polishing pad from the other surface of said machining table, and
the cutting edges have a length which is in a range of 10 to 300% longer than a depth of said groove.

3. The processing method of a polishing pad for semiconductor wafer according to claim 1 or 2, wherein a pattern of said groove is selected from an annular form, a lattice-like form and a spiral form.

4. The processing method of a polishing pad for semiconductor wafer according to claim 1 or 2, wherein said crosslinked polymer is at least one selected from the group consisting of a crosslinked rubber, a cured resin, a crosslinked thermoplastic resin and a crosslinked elastomer.

5. The processing method of a polishing pad for semiconductor wafer according to claim 1 or 2, wherein said water-soluble particle is one made of starch, dextrin, cyclodextrin, lactose, mannite, hydroxyproyl cellulose, methyl cellulose, protein, poly vinyl alcohol, poly vinyl pyrrolidone, poly acrylic acid and its salt, polyethylene oxide, water-soluble photosensitive resin, sulfonated poly isoprene, sulfonated poly isoprene copolymers, potassium acetate, potassium nitrate, potassium carbonate, potassium hydrogen carbonate, potassium chloride, potassium bromide, potassium phosphate and magnesium nitrate.


**Patentansprüche**

1. Verfahren des Bearbeitens einer Polieroberfläche eines Polierkissens für Halbleiter-Wafer, umfassend
eine wasserunlösliche Matrix, die ein vernetztes Polymer enthält, und
ein wasserlösliches Teilchen, das in der wasserunlöslichen Matrix dispergiert ist,
wobei das Verfahren aus dem Bilden einer Kerbe mit einer inneren Oberflächenrauheit von 20 μm oder weniger unter Verwendung eines Bearbeitungswerkzeugs mit einer Mehrfachkanteneinheit, ausgestattet mit mehreren Schneidkanten, besteht,
**dadurch gekennzeichnet, dass**
das Polierkissen für Halbleiter-Wafer auf einer Oberflächenseite eines Bearbeitungstischs mit einem Ansaugloch platziert wird,
das Polierkissen für Halbleiter-Wafer auf der einen Oberflächenseite des Bearbeitungstischs durch Vakuumansaugen des Polierkissens von der anderen Oberfläche des Bearbeitungstischs fixiert wird, und
die Schneidkanten eine Breite aufweisen, welche in einem Bereich von 0,1 bis 10% breiter als eine Breite der Kerbe ist.

2. Verfahren des Bearbeitens einer Polieroberfläche eines Polierkissens für Halbleiter-Wafer, umfassend
eine wasserunlösliche Matrix, die ein vernetztes Polymer enthält, und
ein wasserlösliches Teilchen, das in der wasserunlöslichen Matrix dispergiert ist,
wobei das Verfahren aus dem Bilden einer Kerbe mit einer inneren Oberflächenrauheit von 20 μm oder weniger unter Verwendung eines Bearbeitungswerkzeugs mit einer Mehrfachkanteneinheit, ausgestattet mit mehreren Schneidkanten, besteht,
**dadurch gekennzeichnet, dass**
das Polierkissen für Halbleiter-Wafer auf einer Oberflächenseite eines Bearbeitungstischs mit einem Ansaugloch platziert wird,
das Polierkissen für Halbleiter-Wafer auf der einen Oberflächenseite des Bearbeitungstischs durch Vakuumansaugen des Polierkissens von der anderen Oberfläche des Bearbeitungstischs fixiert wird, und
die Schneidkanten eine Länge aufweisen, welche in einem Bereich von 10 bis 300% länger als eine Tiefe der Kerbe ist.

3. Bearbeitungsverfahren eines Polierkissens für Halbleiter-Wafer nach Anspruch 1 oder 2, wobei ein Muster der Kerbe aus einer Ringform, einer gitterartigen Form und einer Spiralform ausgewählt ist.

4. Bearbeitungsverfahren eines Polierkissens für Halbleiter-Wafer nach Anspruch 1 oder 2, wobei das vernetzte Polymer zumindest eines ist, das aus der Gruppe bestehend aus einem vernetzten Gummi, einem gehärteten Harz, einem vernetzten thermoplastischen Harz und einem vernetzten Elastomer ausgewählt ist.

5. Bearbeitungsverfahren eines Polierkissens für Halbleiter-Wafer nach Anspruch 1 oder 2, wobei das wasserlösliche Teilchen eines ist, das hergestellt ist aus Stärke, Dextrin, Cyclodextrin, Laktose, Mannit, Hydroxypropylcellulose, Methylcellulose, Protein, Polyvinylalkohol, Polyvinylpyrrolidon, Polyacrylsäure und deren Salz, Polyethylenoxid, wasserlöslichem photosensitivem Harz, sulfoniertem Polyisopren, sulfonierten Polyisoprencopolymeren, Kaliumacetat, Kaliumnitrat, Kaliumcarboat, Kaliumhydrogencarbonat, Kaliumchlorid, Kaliumbromid, Kaliumphosphat und Magnesiumnitrat.

## Revendications

1. Procédé destiné à traiter une surface de polissage d'un tampon de polissage pour plaquettes semi-conductrices comprenant

   une matrice insoluble dans l'eau contenant un polymère réticulé et

   une particule soluble dans l'eau dispersée dans ladite matrice insoluble dans l'eau,

   le procédé consistant à former une rainure ayant une rugosité de surface interne de 20 $\mu$m ou moins avec l'utilisation d'un outil d'usinage ayant une unité à bords multiples équipée de plusieurs bords tranchants **caractérisé en ce que**

   ledit tampon de polissage pour plaquettes semi-conductrices est placé sur un côté de surface d'une table d'usinage ayant un trou d'aspiration,

   ledit tampon de polissage pour plaquettes semi-conductrices est fixé sur le côté de surface de ladite table d'usinage par aspiration sous vide dudit tampon de polissage depuis l'autre surface de ladite table d'usinage, et

   les bords tranchants ont une largeur qui est dans une plage de 0.1 à 10% plus large qu'une largeur de ladite rainure.

2. Procédé destiné à traiter une surface de polissage d'un tampon de polissage pour plaquettes semi-conductrices comprenant

   une matrice insoluble dans l'eau contenant un polymère réticulé et

   une particule soluble dans l'eau dispersée dans ladite matrice insoluble dans l'eau,

   le procédé consistant à former une rainure ayant une rugosité de surface interne de 20 $\mu$m ou moins avec l'utilisation d'un outil d'usinage ayant une unité à bords multiples équipée de plusieurs bords tranchants **caractérisé en ce que**

   ledit tampon de polissage pour plaquettes semi-conductrices est placé sur un côté de surface d'une table d'usinage ayant un trou d'aspiration,

   ledit tampon de polissage pour plaquettes semi-conductrices est fixé sur le côté de surface de ladite table d'usinage par aspiration sous vide dudit tampon de polissage depuis l'autre surface de ladite table d'usinage, et

   les bords tranchants ont une longueur qui est dans une plage de 10 à 300% plus longue qu'une profondeur de ladite rainure.

3. Procédé de traitement d'un tampon de polissage pour plaquette semi-conductrice selon la revendication 1 ou 2, dans lequel un motif de ladite rainure est sélectionné d'une forme annulaire, d'une forme en treillis et d'une forme en spirale.

4. Procédé de traitement d'un tampon de polissage pour plaquette semi-conductrice selon la revendication 1 ou 2, dans lequel ledit polymère réticulé est au moins un polymère sélectionné du groupe constitué d'un caoutchouc réticulé, d'une résine cuite, d'une résine thermoplastique réticulée et d'un élastomère réticulé.

5. Procédé de traitement d'un tampon de polissage pour plaquette semi-conductrice selon la revendication 1 ou 2, dans lequel ladite particule soluble dans l'eau est une particule faite d'amidon, de dextrine, de cyclodextrine, de lactose, de mannitol, d'hydroxypropylcellulose, de méthylcellulose, de protéine, d'alcool polyvinylique, de pyrrolidone polyvinylique, d'acide polyacrylique et son sel, d'oxyde de polyéthylène, de résine photosensible soluble dans l'eau, de polyisoprène sulfoné, de copolymères polyisoprène sulfoné, d'acétate de potassium, de nitrate de potassium, de carbonate de potassium, d'hydrocarbonate de potassium, de chlorure de potassium, de bromure de potassium, de phosphate de potassium et de nitrate de magnésium.

# Fig.1

(a)

(b)

(c)

Fig.2

Fig.3

Fig.4

1d

1c

1b

1a

Fig.5

(a)

11a
11

(b)

11b 9

11a    11

Fig.6

(a)

(b)

# Fig.7

(a)

(b)

# Fig.8

(a)

(b)

Fig.9

(a)        B1

(b)        B1

$\theta_3$        $\theta_3$

$\theta_1$

$\theta_2$

L

Fig.10

(a)                    (b)

B 3                    B 3

B42

B41

B42

B 2

B 5        B 5

B 1                    B 2

Fig.11

(a)

(b)

Fig.12

(a)

(b)

Fig.13

B 3

B42

B 2

Fig.14

B 3

B42

B 2

Fig.15

Fig.16

Fig.17

Fig.18

Fig.19

Fig.20

Fig.21

Fig.22

Fig.23

**EP 1 447 841 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 201368 A
- JP 2002011630 A
- JP 2001018164 A
- EP 1201368 A